# EUROPÄISCHE PATENTSCHRIFT

(11) **EP 3 518 340 B1**
(45) Veröffentlichungstag und Bekanntmachung des Hinweises auf die Patenterteilung: **17.03.2021**
(21) Anmeldenummer: 19154438.6
(22) Anmeldetag: 30.01.2019
(51) Int. Cl.: H01P 1/205, H04W 88/08, H01Q 1/24

(54) **HF-COMBINER FÜR EINE MOBILFUNK-SITE, HF-COMBINERANORDNUNG MIT ZWEI HF-COMBINERN FÜR EINE MOBILFUNK-SITE UND EINE SOLCHE MOBILFUNK-SITE**
HF-COMBINER FOR MOBILE RADIO SITE, HF-COMBINER ASSEMBLY WITH TWO HF-COMBINERS FOR A MOBILE RADIO SITE AND SUCH A MOBILE RADIO SITE
COMBINEUR HF POUR UN SITE DE TÉLÉPHONIE MOBILE, AGENCEMENT COMBINEUR HF POURVU DE DEUX COMBINEURS HF POUR UN SITE DE TÉLÉPHONIE MOBILE ET UN TEL SITE DE TÉLÉPHONIE MOBILE

(30) Priorität: 30.01.2018 DE 102018102056
(43) Veröffentlichungstag der Anmeldung: 31.07.2019
(73) Patentinhaber: TELEFONAKTIEBOLAGET LM ERICSSON (PUBL), 164 83 Stockholm (SE)
(72) Erfinder: Müller, Kai-Uwe, 83404 Ainring (DE); Lopes, Joao, 70435 Stuttgart (DE); Sieben, Bernhard, 84088 Neufahrn in Niederbayern (DE)
(74) Vertreter: Flach Bauer Stahl Patentanwälte Partnerschaft mbB

(56) Entgegenhaltungen:
- CN-U- 202 268 461
- CN-U- 202 309 708
- DE-A1-102015 011 182
- US-A1- 2010 045 402
- US-A1- 2017 257 207

## Beschreibung

HF-Combiner für eine Mobilfunk-Site, HF-Combineranordnung mit zwei HF-Combinern für eine Mobilfunk-Site und eine solche Mobilfunksite

Die Erfindung betrifft einen HF-Combiner, der auch als Mobilfunk-Combiner bezeichnet werden kann und für den Aufbau einer Mobilfunk-Site eingesetzt werden kann. Weiterhin betrifft die Erfindung eine HF-Combineranordnung mit zwei solchen HF-Combinern und eine entsprechende Mobilfunksite, in welcher zumindest zwei HF-Combiner oder zumindest eine HF-Combineranordnung eingesetzt wird.

HF-Combiner dienen dazu, Mobilfunksignale von unter-schiedlichen Mobilfunkbändern, also mit unterschiedlichen Frequenzbereichen, zusammenzuführen, um diese über ein gemeinsames Kabel zu den Antennen auf einem Antennenmast übertragen zu können. Ein Kabel, auch Feeder-Kabel genannt, ist teuer in der Herstellung, weil es sehr gute elektrische Eigenschaften aufweisen muss (z. B. bezüglich dielektrischen Verlusten). Daher wird versucht, möglichst viele unterschiedliche Mobilfunkbänder über ein Feeder-Kabel zu übertragen. Ein solches Zusammenführen oder Trennen von Mobilfunkbändern gelingt mit HF-Combinern. Ein HF-Combiner umfasst mehrere Signalleitungsanschlüsse, die an die unterschiedlichen Basisstationen angeschlossen werden. Eine Basisstation empfängt einen digitalen Datenstrom, bereitet diesen auf und gibt ihn in einem HF-Signal aus. Der HF-Combiner führt HF-Signale unterschiedlicher Frequenzen von verschiedenen Basisstationen zusammen und gibt diese an einem Common-Anschluss aus, an dem ein Ende des Feeder-Kabels angeschlossen ist. Am anderen Ende des Feeder-Kabels sind die elektrischen Funktionseinheiten angeschlossen. Unter dem Begriff "elektrische Funktionseinheiten" sind neben den Antennen selbst auch häufig noch andere Komponenten zu verstehen wie beispielsweise Phasenschieber, RET-Einheiten (Remote Electrical Tilt - RET) und DTMAs (Dual Tower Mounted Amplifier). Um diese weiteren Komponenten der elektrischen Funktionseinheiten betreiben und ansteuern zu können, gibt die jeweilige Basisstation noch eine Versorgungsspannung (DC-Signal) und Steuersignale (AISG-Signale) aus. Diese AISG-Signale (Antenna Interface Standard Group - AISG) werden auf einer Frequenz von 2,176 MHz übertragen. Dabei wird ein On-/Off-Keying-Verfahren eingesetzt. Es können dabei Datenraten von beispielsweise 9,6 kbps, 38,4 kbps oder 115,2 kbps erreicht werden. Die Bandbreite eines AISG-Signals beträgt vorzugsweise 200 kHz oder weniger. Der Pegel für das On-/Off-Keying-Signal liegt z. B. bei +5 dBm (On-Signal) und bei beispielsweise -40 dBm (Off-Signal).

Ein solcher Combiner ist der CN 202 268 461 U zu entnehmen. Dieser umfasst zwei Signalanschlüsse und einen gemeinsamen Common-Anschluss. Zwischen jedem Signalanschluss und dem Common-Anschluss ist jeweils ein Transistor angeordnet. Liegt an einem oder beiden Signalanschlüssen ein DC-Signal an, dann wird dieses dem Gate-Anschluss des jeweiligen Transistors zugeführt, der daraufhin zu leiten beginnt. Dadurch werden dann sowohl das DC-Signal als auch das AISG-Signal zum Common-Anschluss übertragen.

Die CN 202 309 708 U beschreibt den gestackten Aufbau einer Verstärkeranordnung für eine Mobilfunkantenne. Die Verstärkeranordnung umfasst einen ersten Verstärker und einen zweiten Verstärker. Diese umfassen jeweils einen Duplexer in einer Cavity-Bauform, einen Low-Noise-Amplifier und einer Steuereinrichtung auf einer Leiterplatte. Die beiden Duplexer sind mit ihren in einer Richtung geöffneten Gehäusen aufeinandergesetzt, wobei die Leiterplatten dazwischen angeordnet sind.

Damit die eingesetzten HF-Combiner unterschiedliche Mobilfunkbänder (unterschiedliche Frequenzbereiche) an den einzelnen Signalleitungsanschlüssen zu einem gemeinsamen Anschluss (Common-Anschluss) übertragen können, an dem das Feeder-Kabel angeschlossen ist, werden unterschiedliche Filterpfade eingesetzt. Dadurch wird auch gewährleistet, dass Signale, die von einem Feeder-Kabel empfangen werden, an den richtigen Signalleitungsanschlüssen ausgegeben werden. Die von der Basisstation zu sendenden Signale können über dasselbe Feeder-Kabel übertragen werden, über das auch die von der Basisstation zu empfangenen Signale übertragen werden. Es können hier für Uplink und Downlink allerdings auch unterschiedliche Feeder-Kabel und damit Combiner eingesetzt werden. Die Filterpfade sind insbesondere als Bandpässe realisiert, weshalb ein DC-Signal und ein AISG-Signal, die zur Steuerung der oben genannten elektrischen Funktionseinheiten notwendig sind, nicht über diese Filterpfade übertragen werden können. Aus diesem Grund gibt es Umgehungsleitungen, die außerhalb der Filterpfade verlaufen. Über diese Umgehungsleitungen werden das DC-Signal und das AISG-Signal übertragen. Diese werden dabei an den Signalleitungsanschlüssen ausgekoppelt und an dem Common-Anschluss wieder eingekoppelt. Damit nicht noch zusätzlich die jeweiligen HF-Signale der Mobilfunkbänder ausgekoppelt werden, sind hier Tiefpässe vorgesehen.

Eine Basisstation hat insbesondere zwei Anschlüsse. An einem Anschluss wird das MAIN-Signal und an einem anderen Anschluss das DIV-Signal ausgegeben bzw. empfangen. Beide Signale sind um 90° phasenverschoben und werden beispielsweise von unterschiedlichen Dipolen eines Vektordipols oder Dipolquadrats ausgesendet bzw. empfangen. Der Frequenzbereich ist dabei derselbe. Die Basisstation gibt allerdings lediglich an einem der Anschlüsse ein AISG-Signal aus.

Bei bisherigen HF-Combinern aus dem Stand der Technik werden einzelne Signalleitungsanschlüsse über Umgehungsleitungen fest mit dem Common-Anschluss verbunden. In diesem Fall können DC-Signale und AISG-Signale nur von einem Signalleitungsanschluss an den Common-Anschluss übertragen werden. Nachdem ein Signalleitungsanschluss, aufgrund des an diesen angeschlossenen Filterpfads, lediglich zum Anschluss eines Mobilfunkbands dient, sind verschiedene HF-Combiner notwendig, um die AISG-Signale von jeder Basisstation über das Feeder-Kabel an die zu steuernden elektrischen Funktionseinheiten übertragen zu können. Dies macht die Herstellung der HF-Combiner aufwändig und es besteht immer die Gefahr, dass es beim Aufbau einer Mobilfunk-Site zu einer fehlerhaften Verkabelung kommt und die Mobilfunk-Site nicht in Betrieb gehen kann.

Grundsätzlich könnte überlegt werden, denjenigen Signalleitungsanschluss über eine entsprechende niederfrequente Auskopplung mit dem Common-Anschluss zu verbinden, bei dem als erstes ein DC-Signal anliegt. Allerdings würde auch hier das Problem bestehen, dass für den Fall, dass die Basisstationen in einer unterschiedlichen zeitlichen Abfolge betriebsbereit sind und in einer unterschiedlichen zeitlichen Abfolge ein DC-Signal ausgeben, die Zusammenschaltung vom Signalleitungsanschluss zum Common-Anschluss fehlerhaft wäre. In diesem Fall würde der HF-Combiner diese Zusammenschaltung auch dann nicht mehr korrigieren, wenn anschließend an einem anderen Signalleitungsanschluss plötzlich ein AISG-Signal von einer anderen Basisstation anliegt, die erst später gestattet wurde.

Es ist daher die Aufgabe der hier vorliegenden Erfindung, einen HF-Combiner zu schaffen, der sich zum Aufbau einer Mobilfunk-Site eignet, obwohl an seinen Signalleitungsanschlüssen MAIN- bzw. DIV-Signale von unterschiedlichen Basisstationen anliegen und im Vorfeld nicht definiert wird, an welchem Signalleitungsanschluss ein AISG-Signal anliegt.

Die Aufgabe wird durch den HF-Combiner gemäß dem unabhängigen Anspruch 1, durch eine HF-Combineranordnung gemäß dem Anspruch 14 und durch eine Mobilfunksite gemäß dem Anspruch 15 gelöst. Den Ansprüchen 2 bis 13 sind erfindungsgemäße Weiterbildungen des HF-Combiners zu entnehmen.

Der erfindungsgemäße HF-Combiner umfasst ein Gehäuse, an dem ein Common-Anschluss und n Signalleitungsanschlüsse (mit n ≥ 2) angeordnet sind. Die n Signalleitungsanschlüsse sind innerhalb des Gehäuses mit dem Common-Anschluss über jeweils einen von n Filterpfaden verbunden und/oder gekoppelt. Bei den Filterpfaden handelt es sich insbesondere um Bandpässe, über die die Mobilfunksignale von dem jeweiligen Signalleitungsanschluss zu dem Common-Anschluss bzw. von dem Common-Anschluss zu dem jeweiligen Signalleitungsanschluss übertragen werden können. Es ist weiterhin eine Leiterplattenanordnung vorgesehen. Diese dient zur Übertragung der ausgekoppelten niederfrequenten Signale (DC-Signal und AISG-Signal). Die Leiterplattenanordnung weist hierzu eine Common-Anschlusskontaktierung auf, die mit dem Common-Anschluss galvanisch über einen Tiefpass verbunden ist. Weiterhin weist sie n Signalleitungsanschlusskontaktierungen auf, wobei jede der n Signalleitungsanschlusskontaktierungen mit dem jeweiligen Signalleitungsanschluss galvanisch über einen Tiefpass verbunden ist. Im einfachsten Fall handelt es sich bei den Anschlusskontaktierungen um Lötstellen oder Stecker auf der Leiterplattenanordnung. Die n Signalleitungsanschlusskontaktierungen sind dabei über n Umgehungsleitungen mit der Common-Anschlusskontaktierung verbunden oder verbindbar. Diese Umgehungsleitungen laufen an der Common-Anschluss-kontaktierung zusammen. Weiterhin gibt es eine Elektronikeinrichtung, die eine Steuervorrichtung, eine Detektoreinrichtung und zumindest n Signalleitungsschalteinrichtungen aufweist. Jede dieser Signalleitungsschalteinrichtungen umfasst eine erste Schalteinheit. In jeder der n Umgehungsleitungen ist eine dieser Schalteinheiten angeordnet, wobei die Schalteinheiten bei Betätigung dazu ausgebildet sind, die jeweilige Umgebungsleitung zu unterbrechen oder durchzuverbinden, wobei im letzteren Fall die entsprechende Signalleitungsanschlusskontaktierung mit der Common-Anschlusskontaktierung elektrisch verbunden ist. Ein AISG-Signal, das an der entsprechenden Signalleitungsanschlusskontaktierung anliegt wird dann an die Common-Anschlusskontaktierung übertragen. Die Übertragung erfolgt umsetzungsfrei. Dies bedeutet, dass das AISG-Signal nicht noch durch zusätzliche Modems (Signalumsetzer) in ein anderes Protokoll umgesetzt wird. Die Umgehungsleitung zur Übertragung des AISG-Signals zwischen der entsprechenden Signalleitungsanschlusskontaktierung und der Common-Anschlusskontaktierung ist daher frei von Modems. Die Übertragung erfolgt dabei bevorzugt rein passiv. Das bedeutet, dass das Signal nicht verändert, also z.B. nicht verstärkt wird. Die Verbindung zwischen der entsprechenden Signalleitungsanschlusskontaktierung und der Common-Anschlusskontaktierung ist vorzugsweise niederohmig. Die Detektoreinrichtung, die bevorzugt n Signalleitungsdetektoreinrichtungen umfasst, ist entweder an der jeweiligen Signalleitungsanschlusskontaktierung angeschlossen oder angekoppelt oder jeweils zwischen einem der n Signalleitungsanschlüsse und der ersten Schalteinheit. Die Detektoreinrichtung ist in einem BTS-Betriebszustand dazu ausgebildet, zu detektieren, ob an einer der n Signalleitungsanschlusskontaktierungen ein AISG-Signal anliegt. Die Steuervorrichtung oder die Detektoreinrichtung ist bei einer solchen Detektion dazu ausgebildet, die erste Schalteinheit in der jeweiligen der n Umgehungsleitungen derart anzusteuern, dass diese diejenige der n Signalleitungsanschlusskontaktierungen, an welcher das AISG-Signal detektiert wurde, mit der Common-Anschlusskontaktierung elektrisch verbindet. Durch diese elektrische Verbindung wird das AISG-Signal (niederohmig) von der entsprechenden Signalleitungsanschlusskontaktierung an die Common-Anschlusskontaktierung übertragen.

Es ist besonders vorteilhaft, dass eine Detektoreinrichtung vorgesehen ist, mit der ein AISG-Signal an einer der n Signalleitungsanschlusskontaktierungen detektiert werden kann. Dieses Ergebnis wird dann dazu verwendet, um dieses AISG-Signal über die jeweilige erste Schalteinheit an die Common-Anschlusskontaktierung weiterzuleiten, so dass es am Common-Anschluss zur Verfügung steht. In diesem Fall ist es egal, ob das AISG-Signal an dem ersten oder zweiten oder dritten Signalleitungsanschluss des HF-Combiners zugeführt wird. Unter einem BTS-Betriebszustand ist zu verstehen, dass der HF-Combiner an die Basisstationen angeschlossen wird. Die jeweiligen Signalleitungsanschlüsse sind daher mit den Anschlüssen der Basisstationen (zumindest mittelbar) verbunden, wohingegen der Common-Anschluss mit dem Feeder-Kabel verbunden ist. Der HF-Combiner befindet sich daher "am Boden" und nicht "oben auf dem Antennenmast".

Aus der US 2017/257207 A1 ist ebenfalls ein Combiner mit Umgehungsleitungen bekannt, die an entsprechende Anschlussports angeschlossen sind. Ein "Bias Tee" trennt jede der Umgehungsleitungen in eine AISG-Leitung und eine DC-Leitung auf, wobei über die AISG-Leitung nur AISG-Signale übertragen werden und über die DC-Leitung nur DC-Signale. Im Unterschied zu der erfindungsgemäßen Lösung, bei welcher die Detektoreinrichtung ein AISG-Signal detektiert, erfolgt dort lediglich die Detektion eines DC-Signals. Wird ein DC-Signal detektiert, dann wird die DC-Leitung mit dem Common-Anschluss verbunden. Die dazugehörige AISG-Leitung desselben Anschlussports wird dagegen nicht elektrisch, gemäß der erfindungsgemäßen Lösung, mit dem Common-Anschluss verbunden, sondern galvanisch getrennt über zwei Modems. Ein erstes Modem wandelt das AISG-Signal auf der AISG-Leitung, welches eine OOK-Modulation (on-off-keying) umfasst, in ein TTL-Signal um. Das zweite Modem setzt das TTL-Signal wiederum in ein AISG-Signal um und gibt dieses an dem Common-Anschluss aus. Durch Einsatz derartiger Modems wird keine elektrische Verbindung zur Übertragung des AISG-Signals zwischen dem jeweiligen Anschlussport und dem Common-Anschluss hergestellt.

Die Detektoreinrichtung kann über eine galvanische Verbindung oder über eine (kapazitive oder induktive) Kopplung das Vorliegen eines AISG-Signals detektieren. Dies wird durch den Wortlaut "angeschlossen" oder "angekoppelt" beschrieben.

In einer bevorzugten Ausführungsform des erfindungsgemäßen HF-Combiners ist die Detektoreinrichtung zusätzlich entweder an der Common-Anschlusskontaktierung angeschlossen oder angekoppelt oder zwischen dem Common-Anschluss und den n Signalleitungsschalteinrichtungen. Die Detektoreinrichtung weist bevorzugt eine Common-Detektoreinrichtung auf Die Detektoreinrichtung ist dazu ausgebildet zu detektieren, ob an einer der n Signalleitungsanschlusskontaktierungen ein DC-Signal anliegt. Die Detektoreinrichtung ist weiterhin dazu ausgebildet zu detektieren, ob an der Common-Anschlusskontaktierung ein DC-Signal anliegt. Beim Starten der Steuervorrichtung, also insbesondere wenn diese nach einem spannungslosen Zustand erstmalig mit Strom versorgt wird, nimmt diese einen Startbetriebszustand ein. Von diesem Startbetriebszustand kann sie entweder in den BTS-Betriebszustand oder in einen ANT-Betriebszustand wechseln. In den BTS-Betriebszustand geht die Steuervorrichtung dann über, wenn die Detektoreinrichtung ein DC-Signal an einer der n Signalleitungsanschlusskontaktierungen detektiert. Dagegen geht die Steuervorrichtung in den ANT-Betriebszustand über, wenn die Detektoreinrichtung ein DC-Signal an der Common-Anschlusskontaktierung detektiert. Dadurch kann der erfindungsgemäße HF-Combiner universell eingesetzt werden. Er detektiert selbständig, ob er an den Basisstationen angeordnet ist oder oben auf dem Antennenmast bei den elektrischen Funktionseinheiten. Es ist daher lediglich ein HF-Combiner notwendig, der seinen jeweiligen Einsatzort und Einsatzzweck selbständig detektiert und seine Funktionalität entsprechend einstellt. Unter dem ANT-Betriebszustand ist zu verstehen, dass der HF-Combiner an die elektrischen Funktionseinheiten angeschlossen wird. Die jeweiligen Signalleitungsanschlüsse sind daher z. B. mit den Anschlüssen der Antennen unmittelbar verbunden. Eine mittelbare Verbindung kann sich dadurch ergeben, dass diese mit den Anschlüssen von SingleBand-DTMAs oder DualBand-DTMAs verbunden sind, die wiederum an die Antennen angeschlossen sind. Der Common-Anschluss ist dabei mit dem Feeder-Kabel verbunden. Der HF-Combiner befindet sich daher "auf dem Antennenmast" und nicht "unten an den Basisstationen".

Wie eingangs erläutert, umfassen die Basisstationen zumindest zwei Anschlüsse. In einem ersten Anschluss wird das MAIN-Signal und in einem zweiten Anschluss das DIV-Signal ausgegeben bzw. empfangen. Beide Signale belegen denselben Frequenzbereich, sind allerdings um 90° phasenverschoben zueinander. Beide Signale können daher nicht über dasselbe Feeder-Kabel übertragen werden. Folglich benötigt es zumindest zwei HF-Combiner, die an unterschiedliche Feeder-Kabel angeschlossen sind. Aufgrund der entsprechenden Sendeleistungen sind diese HF-Combiner bevorzugt in Cavity-Bauweise aufgebaut. Das Gehäuse umfasst einen Gehäuseboden, sowie die vom Gehäuseboden beabstandete Leiterplattenanordnung und eine zwischen dem Gehäuseboden und der Leiterplattenanordnung umlaufende Gehäusewand, wodurch ein entsprechender Aufnahmeraum begrenzt ist. Für jeden Filterpfad ist zumindest ein Resonator-Innenleiter vorgesehen, der mit dem Gehäuseboden des Gehäuses galvanisch verbunden ist und sich in axialer Richtung vom Gehäuseboden in Richtung der Leiterplattenanordnung erstreckt und in einem Abstand von der Leiterplattenanordnung endet und/oder von dieser galvanisch getrennt ist. Die einzelnen Filterpfade, in denen jeweils zumindest ein Resonator-Innenleiter angeordnet ist, sind voneinander zumindest teilweise durch eine Wand getrennt (entkoppelt), die galvanisch mit dem Gehäuse verbunden ist und sich in Richtung der Leiterplattenanordnung erstreckt und vorzugsweise ebenfalls galvanisch mit dieser verbunden ist. Ein solches Gehäuse wird vorzugsweise in einem (Aluminium-) (Druck-) Gussverfahren hergestellt. Alternativ oder ergänzend dazu kann auch ein Fräsprozess verwendet werden. Die einzelnen HF-Combiner werden dann noch mit einer Deckelanordnung verschlossen.

Nachdem das MAIN-Signal und das DIV-Signal einer Basisstation über zwei verschiedene HF-Combiner übertragen werden müssen, ist in einer erfindungsgemäßen Weiterbildung eine HF-Combiner-Anordnung beschrieben. Diese umfasst einen ersten und einen zweiten HF-Combiner, die in Cavity-Bauweise aufgebaut sind. Um die Kosten zu reduzieren, wurde auf den Einsatz von entsprechenden Gehäusedeckeln erfindungsgemäß verzichtet. Der erste und der zweite HF-Combiner sind aufeinandergesetzt, wobei die Leiterplattenanordnung den Aufnahmeraum des ersten HF-Combiners von dem Aufnahmeraum des zweiten HF-Combiners elektrisch bzw. elektromagnetisch trennt und umgekehrt. Insbesondere liegen die Stirnseiten der Gehäusewände beider HF-Combiner aufeinander auf, wobei die Leiterplattenanordnung die jeweiligen Aufnahmeräume voneinander trennt. Dadurch kann auf besonders kostengünstige Art und Weise eine HF-Combineranordnung geschaffen werden, die jeweils n Signalleitungsanschlüsse für das MAIN-Signal von n Mobilfunkbändern und n Signalleitungsanschlüsse für das DIV-Signal von n Mobilfunkbändern aufweist. Andererseits gibt es zwei Common-Anschlüsse zum Anschluss von zwei Feeder-Kabeln, die wiederum mit den elektrischen Funktionseinheiten auf dem Antennenmast verbunden sind. Ein Aufbau in Streifenleitertechnik bzw. Mikrostreifenleitertechnik wäre auch möglich.

Eingesetzt wird der erfindungsgemäße HF-Combiner bzw. die erfindungsgemäße HF-Combineranordnung in Mobilfunk-Sites. Unter einer Mobilfunk-Site wird die Kombination von Basisstationen, HF-Combinern, Feeder-Kabeln und elektrischen Funktionseinheiten (z. B. DB-DTMA) nebst den eigentlichen Antennenelementen auf dem Antennenmast verstanden. Vorzugsweise umfasst eine solche Mobilfunk-Site zumindest zwei der erfindungsgemäßen HF-Combiner oder zumindest eine der erfindungsgemäßen HF-Combineranordnungen. Weiterhin sind n Basisstationen vorgesehen, die in unterschiedlichen Mobilfunkbändern betreibbar sind. Dabei können beispielsweise auch unterschiedliche Mobilfunkstandards (z.B. LTE, UMTS, GSM) verwendet werden. Jede der n Basisstation umfasst zumindest zwei Signalanschlüsse, wobei die n Basisstationen dazu ausgebildet sind, an einem ersten Signalanschluss ein MAIN-Signal auszusenden und/oder zu empfangen und wobei die n Basisstationen dazu ausgebildet sind, an einem zweiten Signalanschluss ein DIV-Signal auszusenden und/oder zu empfangen. Dabei sind die ersten Signalanschlüsse der n Basisstationen mit den n Signalleitungsanschlüssen des ersten HF-Combiners oder des ersten HF-Combiners der ersten HF-Combineranordnung elektrisch verbunden. Andererseits sind die zweiten Signalanschlüsse der n Basisstationen mit den n Signalleitungsanschlüssen des zweiten HF-Combiners oder des zweiten HF-Combiners der ersten HF-Combineranordnung elektrisch verbunden. Ein erstes Feeder-Kabel ist mit seinem ersten Ende mit dem Common-Anschluss des ersten HF-Combiners oder dem Common-Anschluss des ersten HF-Combiners der ersten HF-Combineranordnung elektrisch verbunden. Ein zweites Feeder-Kabel ist mit seinem ersten Ende mit dem Common-Anschluss des zweiten HF-Combiners oder dem Common-Anschluss des zweiten HF-Combiners der ersten HF-Combineranordnung elektrisch verbunden. Wie bereits erläutert, können an das zweite Ende der Feeder-Kabel entsprechende elektrische Funktionseinheiten angeschlossen werden.

Unabhängig davon, wann die jeweilige Basisstation ihr AISG-Signal ausgibt, wird dieses durch den erfindungsgemäßen HF-Combiner auf das entsprechende Feeder-Kabel durchgeschaltet. Dieses AISG-Signal steht daher am zweiten Ende des jeweiligen Feeder-Kabels zur Verfügung und kann zur Ansteuerung der elektrischen Funktionseinheiten verwendet werden.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnungen zeigen im Einzelnen:
- Figur 1:: eine schematische Ansicht einer Elektronikeinrichtung des erfindungsgemäßen HF-Combiners;
- Figuren 2A, 2B, 2C und 2D:: verschiedene Darstellungen eines Schaltungsteils der Elektronikeinrichtung, durch die ein unterbrechungsfreies Umschalten einer DC-Spannung zwischen zwei Signalleitungsanschlusskontaktierungen hin zu der Common-Anschlusskontaktierung möglich ist;
- Figuren 3A:: eine schematische Ansicht eines Ausführungsbeispiels des erfindungsgemäßen HF-Combiners in geöffneter Darstellung;
- Figur 3B:: eine schematische Schnittdarstellung eines Ausführungsbeispiels des erfindungsgemäßen HF-Combiners;
- Figuren 4A, 4B, 4C:: verschiedene Ansichten einer HF-Combineranordnung;
- Figur 5:: ein Ausführungsbeispiel einer erfindungsgemäßen MobilfunkSite mit zwei HF-Combinern und einem DB-DTMA;
- Figur 6:: ein weiteres Ausführungsbeispiel einer erfindungsgemäßen Mobilfunk-Site mit vier HF-Combinern und zwei SB-DTMAs; und
- Figur 7:: ein weiteres Ausführungsbeispiel einer erfindungsgemäßen Mobilfunk-Site mit vier HF-Combinern, wobei teilweise unmittelbar Antennenelemente an die HF-Combiner angeschlossen sind.

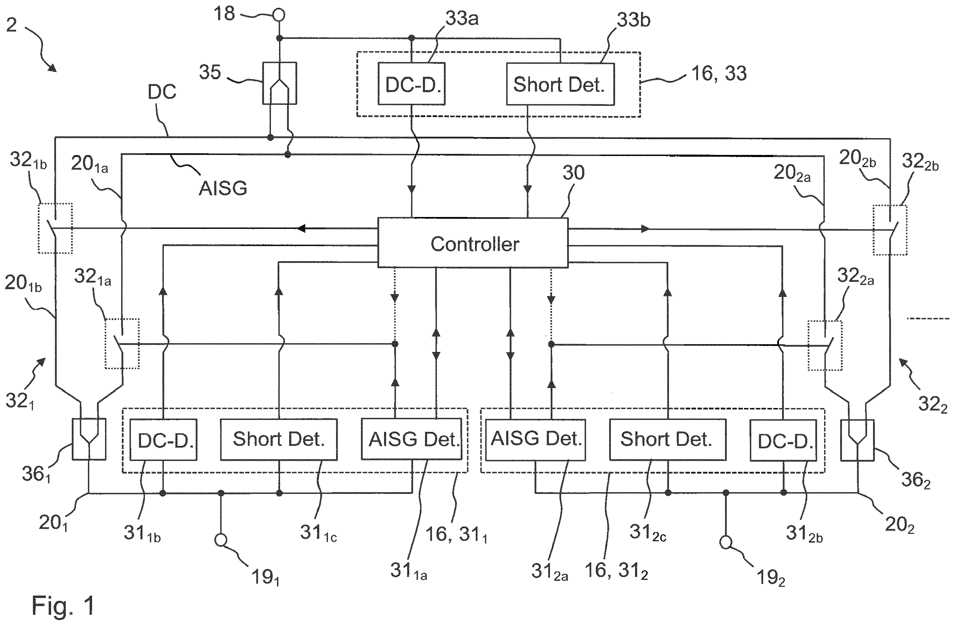

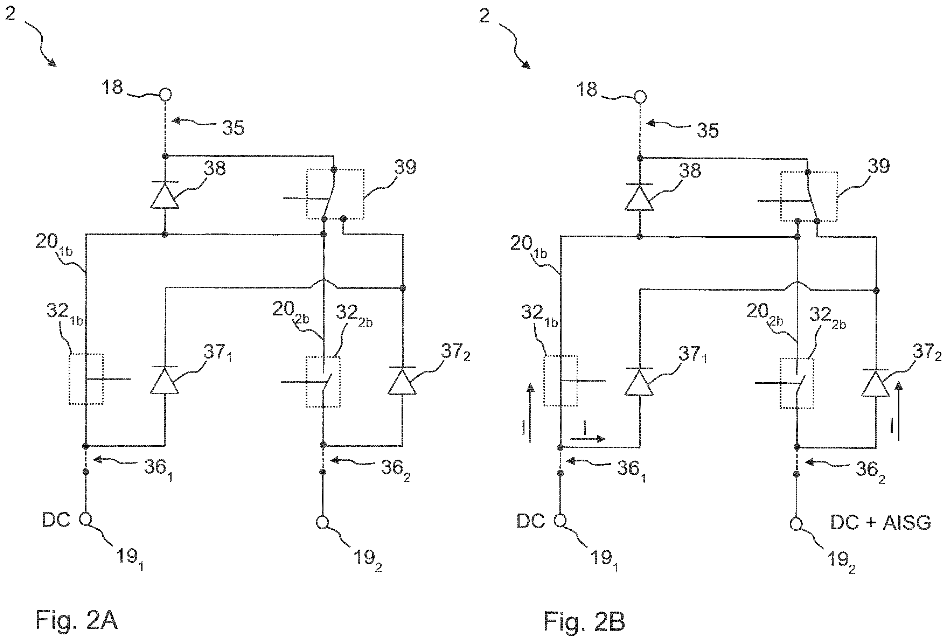

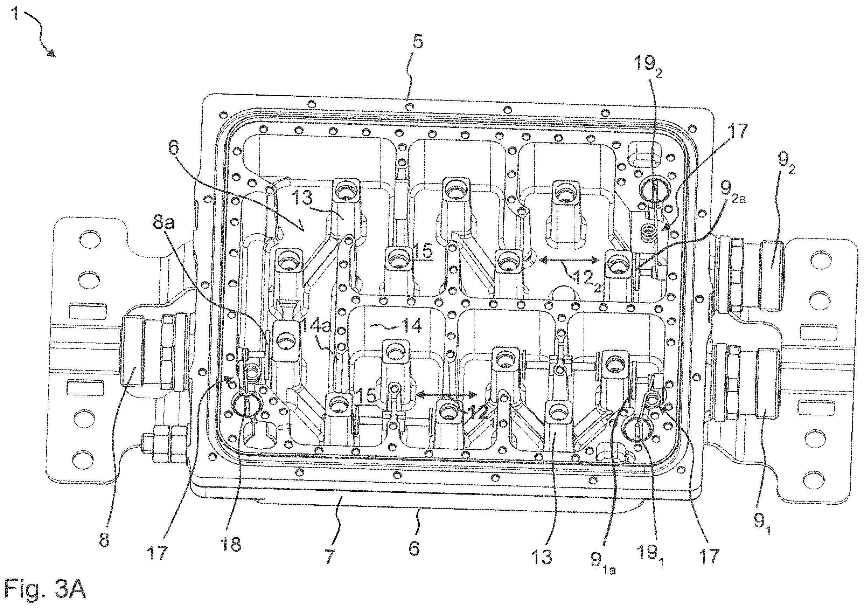

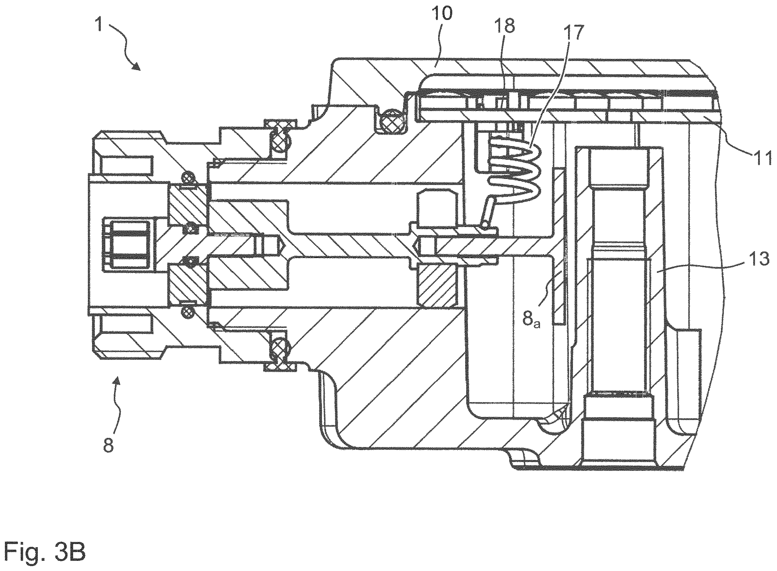

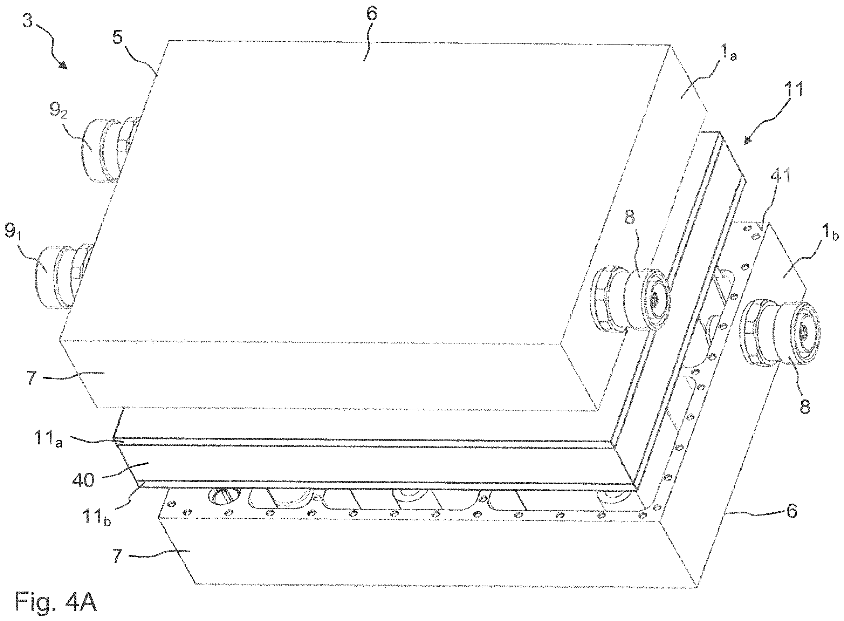

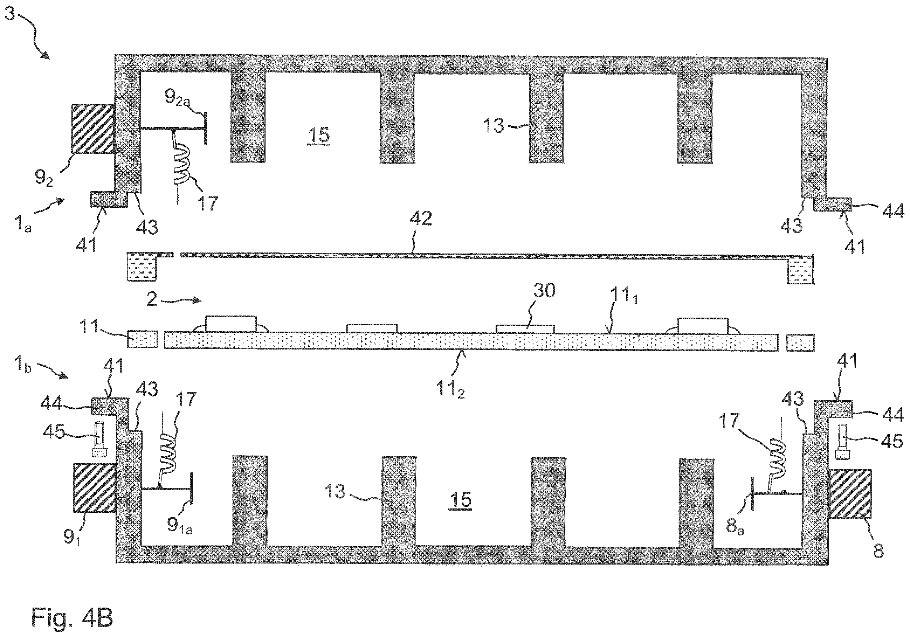

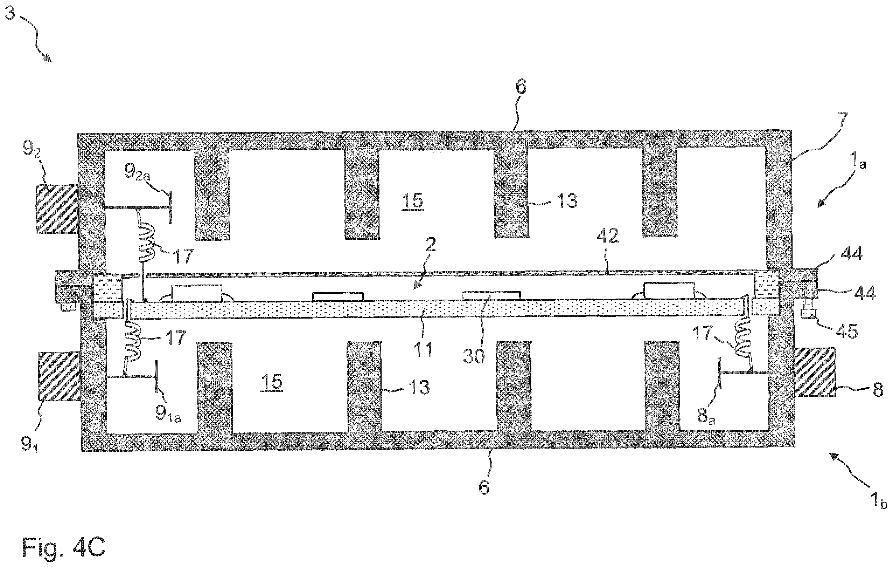

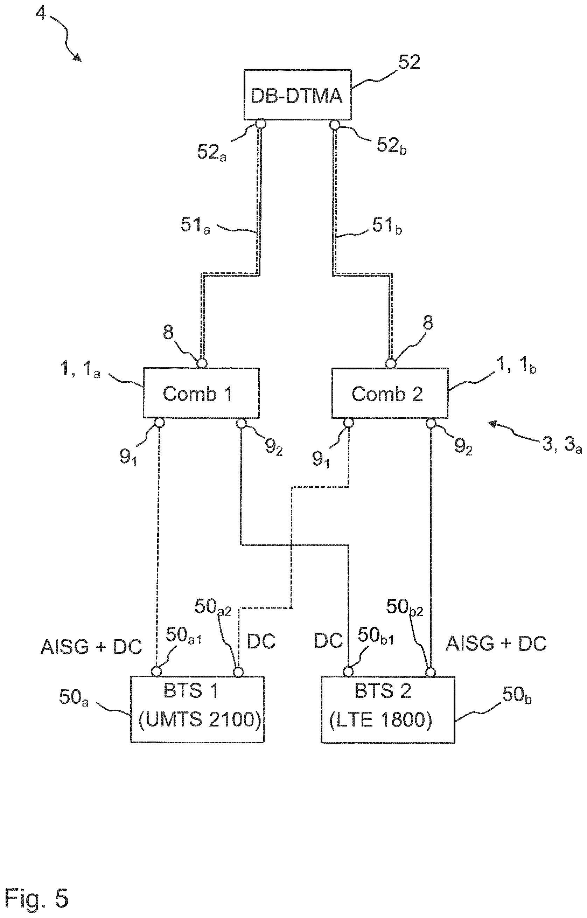

Der erfindungsgemäße HF-Combiner 1 wird in den Figuren 3A und 3B näher beschrieben. Eine Elektronikeinrichtung 2, die auf einer Leiterplattenanordnung 11 angeordnet ist und durch die die niederfrequenten Signale aus- und wieder einkoppelt werden, ist in Figur 1 dargestellt. In den Figuren 2A bis 2D ist ein weiteres Ausführungsbeispiel der Elektronikeinrichtung 2 dargestellt. In den Figuren 4A, 4B und 4C ist ein Ausführungsbeispiel der erfindungsgemäßen HF-Combineranordnung 3 dargestellt. Unterschiedliche Ausführungsbeispiele einer Mobilfunk-Site 4 sind in den Figuren 5, 6 und 7 dargestellt.

Fig. 3A zeigt eine Draufsicht auf einen HF-Combiner 1 in Cavity-Bauweise mit einem abgenommenen Gehäusedeckel 10 (siehe Fig. 3B) und der abgenommenen Leiterplattenanordnung 11 (siehe Fig. 3B). Der HF-Combiner 1 umfasst ein Gehäuse 5, das einen Gehäuseboden 6, die vom Gehäuseboden 6 beabstandete Leiterplattenanordnung 11 und eine zwischen dem Gehäuseboden 6 und der Leiterplattenanordnung 11 umlaufende Gehäusewand 7 umfasst. Die umlaufende Gehäusewand 7 umgrenzt dabei einen Aufnahmeraum 15.

An dem Gehäuse 5, insbesondere an der umlaufenden Gehäusewand 7, sind ein Common-Anschluss 8 und Signalleitungsanschlüsse 9₁, 9₂, ..., 9ₙ angebracht. Insbesondere gibt es zumindest zwei Signalleitungsanschlüsse 9₁, 9₂, wie dies in den Zeichnungsfiguren auch dargestellt ist. Grundsätzlich könnten es allerdings auch mehr Signalleitungsanschlüsse 9₁, 9₂ sein, insbesondere kann n ≥ 2, n ≥ 3 oder n ≥ 4 sein. Die n Signalleitungsanschlüsse 9₁, 9₂, ..., 9ₙ sind vorzugsweise an einer erste Seite der umlaufenden Gehäusewand 7 angeordnet, wohingegen der Common-Anschluss 8 auf einer gegenüberliegenden zweiten Seite der umlaufenden Gehäusewand 7 angeordnet ist.

Innerhalb der Beschreibung wird bei vielen Elementen neben dem Bezugszeichen das tiefgestellte Zeichen "n" angegeben, obwohl dieses in den Zeichnungen aus Platzgründen nicht aufgeführt ist. Das tiefgestellte Zeichen "n" wird dabei bevorzugt bei erstmaliger Verwendung angegeben, um zu verdeutlichen, dass es mehr als zwei dieser Elemente geben kann. Insbesondere kann der erfindungsgemäße HF-Combiner 1, wie gezeigt, als DualBand-Combiner mit n = 2 ausgeführt sein. Er kann allerdings auch als TripleBand-Combiner (n = 3) oder als QuadBand-Combiner (n = 4) ausgeführt sein.

Die n Signalleitungsanschlüsse 9₁, 9₂, ..., 9ₙ sind innerhalb des Gehäuses 5 mit dem Common-Anschluss 8 über jeweils einen von n Filterpfaden 12₁, 12₂, ..., 12ₙ verbunden und/oder gekoppelt.

In jedem Filterpfad 12₁, 12₂, ..., 12ₙ ist zumindest ein Resonator-Innenleiter 13 angeordnet, der mit dem Gehäuseboden 6 des Gehäuses 5 galvanisch verbunden ist und sich in axialer Richtung vom Gehäuseboden 6 in Richtung der Leiterplattenanordnung 11 erstreckt und in einem Abstand von der Leiterplattenanordnung 11 endet und/oder von dieser galvanisch getrennt ist.

Die einzelnen Filterpfade 12₁, 12₂, ..., 12ₙ, in denen jeweils zumindest ein Resonator-Innenleiter 13 angeordnet ist, sind voneinander zumindest teilweise durch eine Wand 14 getrennt. Diese Wand 14 ist galvanisch mit dem Gehäuseboden 6 verbunden und erstreckt sich in Richtung der Leiterplattenanordnung 11. Diese Wand 14 verhindert, dass eine unerwünschte Kopplung zwischen den einzelnen Filterpfaden 12₁, 12₂, ..., 12ₙ erfolgt.

Die Wand 14 kann zusätzliche Wandsegmente 14a umfassen, die die Breite der Filterpfade 12₁, 12₂, ..., 12ₙ von dem Common-Anschluss 8 hin zu den jeweiligen Signalleitungsanschlüssen 9₁, 9₂, ..., 9ₙ begrenzen. Dadurch werden einzelne Resonator-Kammern gebildet, in denen insbesondere die Resonator-Innenleiter 13 angeordnet sind. Die Kopplung der Resonator-Kammern untereinander kann durch diese Wandsegmente 14a eingestellt werden.

Der Common-Anschluss 8 ragt in den Aufnahmeraum 15 innerhalb des Gehäuses 5 hinein und umfasst eine Koppeleinrichtung 8a. Dadurch ist eine kapazitive, induktive oder auch galvanische Kopplung des Common-Anschlusses 8 mit dem (z. B. ersten) Resonator-Innenleiter 13 möglich. Insbesondere findet die Kopplung zu demjenigen Resonator-Innenleiter 13 statt, der am nächsten zu dem Common-Anschluss 8 angeordnet ist. In den Ausführungsbeispielen ist eine kapazitive Kopplung dargestellt.

Selbiges gilt auch für die n Signalleitungsanschlüsse 9₁, 9₂, ..., 9ₙ, die ebenfalls über entsprechende Koppelanschlüsse 9₁ₐ, 9₂ₐ, ..., 9ₙₐ verfügen.

Über diese Koppelanschlüsse 8ₐ, 9₁ₐ, 9₂ₐ, ... 9ₙₐ werden Mobilfunksignale den jeweiligen Filterpfaden 12₁, 12₂, ..., 12ₙ zugeführt bzw. von diesen empfangen.

Über diese Filterpfade 12₁, 12₂, ..., 12ₙ können allerdings nur Hochfrequenzsignale (z. B. > als 300 MHz) übertragen werden. Niederfrequente Signale (z.B. AISG-Signale) und DC-Signale können hierüber nicht übertragen werden. Derartige Signale werden an den jeweiligen Signalleitungsanschlüssen 9₁, 9₂, ..., 9ₙ bzw. am Common-Anschluss 8 ausgekoppelt und über entsprechende Umgehungsleitungen 20₁, 20₂, ..., 20ₙ geführt, um im Common-Anschluss 8 bzw. in den jeweiligen Signalleitungsanschlüssen 9₁, 9₂, ..., 9ₙ wieder eingekoppelt zu werden.

Diese Umgehungsleitungen 20₁, 20₂, ..., 20ₙ sind dabei auf der separaten Leiterplattenanordnung 11 angeordnet (s. Figur 1). Diese weist hierzu eine Common-Anschlusskontaktierung 18 und n Signalleitungsanschlusskontaktierungen 19₁, 19₂, ..., 19ₙ auf. Jede dieser Signalleitungsanschlusskontaktierungen 19₁, 19₂, ..., 19ₙ ist mit dem entsprechenden Signalleitungsanschluss 9₁, 9₂, ..., 9ₙ galvanisch verbunden. Diese Verbindung erfolgt jeweils über ein Anschlusskabel, wobei in diesem noch zumindest ein Tiefpassfilter 17 angeordnet ist, wie dies beispielsweise in Figur 3A durch die Spule dargestellt ist. Dieses Tiefpassfilter 17 stellt sicher, dass keine Mobilfunksignale mitausgekoppelt werden können. Über das Tiefpassfilter 17 können allerdings DC-Signale und AISG-Signale übertragen werden.

Der Common-Anschluss 8 und die n Signalleitungsanschlüsse 9₁, 9₂, ..., 9ₙ eignen sich zum Anschluss von Koaxialkabeln. Ein Außenleiter eines solchen Koaxialkabels wird dabei elektrisch leitend mit dem Gehäuse 5 des HF-Combiners 1 verbunden. Ein Innenleiter eines solchen Koaxialkabels ist galvanisch mit den jeweiligen Koppelanschlüssen 8ₐ, 9₁ₐ, 9₂ₐ, ... 9ₙₐ verbunden.

Gemäß Figur 1 ist jede der n Signalleitungsanschlusskontaktierungen 19₁, 19₂, ... 19ₙ über jeweils eine der n Umgehungsleitungen 20₁, 20₂, ..., 20ₙ mit der Common-Anschlusskontaktierung 18 verbunden bzw. verbindbar. Diese Verbindung ist niederohmig. Der Leitungswiderstand ist insbesondere kleiner als 3 Ω, 2 Ω oder kleiner als 1 Ω.

Die Elektronikeinrichtung 2 umfasst eine Steuervorrichtung 30 und eine Detektoreinrichtung 16. Diese Detektoreinrichtung 16 kann insbesondere ein DC-Signal, AISG-Signal und einen Kurzschluss an jedem der n Signalleitungsanschlüsse 9₁, 9₂, ..., 9ₙ bzw. ein DC-Signal und einen Kurzschluss am Common-Anschluss 8 detektieren. Der Kurzschluss kann beispielsweise über einen Shunt-Widerstand erfasst werden. Auch eine berührungslose Messung wäre möglich. Das DC-Signal und das AISG-Signal können beispielsweise durch A/D-Wandler und/oder Komparatoren erfasst werden. Es wäre z.B. ein A/D-Wandler mit n Eingängen für jeden Signalleitungsanschluss 9₁, 9₂, ..., 9ₙ und einem weiteren Eingang für den Common-Anschluss ausreichend. Dies würde für die Messung des DC-Signals und des AISG-Signals gelten. Es wäre auch möglich, dass nur ein A/D-Wandler bzw. ein Komparator für die Messung aller DC-Signale und aller AISG-Signale verwendet wird. In diesem Fall müssten die jeweiligen Signalleitungsanschlüsse 9₁, 9₂, ..., 9ₙ und der jeweilige Common-Anschluss 8 über entsprechende Multiplex-Schalter sehr schnell nacheinander für die Messung mit dem A/D-Wandler bzw. dem Komparator verbunden werden.

In den Ausführungsbeispielen ist jedoch dargestellt, dass die Detektoreinrichtung 16 bevorzugt durch n Signalleitungsdetektoreinrichtungen 31₁, 31₂, ..., 31ₙ und eine Common-Detektoreinrichtung 33 gebildet ist. Nachfolgend wird daher immer von den n Signalleitungsdetektoreinrichtungen 31₁, 31₂, ..., 31ₙ und der Common-Detektoreinrichtung 33 gesprochen. Alles was für die n Signalleitungsdetektoreinrichtungen 31₁, 31₂, ..., 31ₙ und die Common-Detektoreinrichtung 33 gilt, gilt daher auch für die Detektoreinrichtung 16.

In den Ausführungsbeispielen umfasst die Elektronikeinrichtung 2 daher die Steuervorrichtung 30, die Detektoreinrichtung 16 mit den n Signalleitungsdetektoreinrichtungen 31₁, 31₂, ..., 31ₙ und der Common-Detektoreinrichtung 33 und zumindest n Signalleitungsschalteinrichtungen 32₁, 32₂, ..., 32ₙ.

Die n Signalleitungsschalteinrichtungen 32₁, 32₂, ..., 32ₙ umfassen jeweils eine erste Schalteinheit 32₁ₐ, 32₂ₐ 32ₙₐ. In jeder der n Umgehungsleitungen 20₁, 20₂ ist die jeweilige zumindest eine erste Schalteinheit 32₁, 32₂ angeordnet.

Jede der n Signalleitungsdetektoreinrichtungen 31₁, 31₂ ist an der jeweiligen der n Signalleitungsanschlusskontaktierungen 19₁, 19₂ angeschlossen oder angekoppelt. Sie könnten auch zwischen einem der n Signalleitungsanschlüsse 9₁, 9₂ und der jeweiligen ersten Schalteinheit 32₁ₐ, 32₂ₐ angeschlossen oder angekoppelt sein.

Die n Signalleitungsdetektoreinrichtungen 31₁, 31₂ sind in einem BTS-Betriebszustand dazu ausgebildet zu detektieren, ob an einer der n Signalleitungsanschlusskontaktierungen 19₁, 19₂ ein AISG-Signal anliegt. Hierzu umfassen die n Signalleitungsdetektoreinrichtungen 31₁, 31₂ eine AISG-Detektoreinheit 31₁ₐ, 31₂ₐ, ..., 31ₙₐ. In dem Ausführungsbeispiel umfassen die Signalleitungsdetektoreinrichtungen 31₁, 31₂ noch jeweils eine DC-Detektoreinheit 31_{1b}, 31_{2b}, ..., 31_{nb} und eine Kurzschluss-Detektoreinheit 31_{1c}, 31_{2c}, ..., 31_{nc}.

Die Common-Detektoreinrichtung 33 umfasst vorzugsweise eine DC-Detektoreinheit 33ₐ und eine Kurzschluss-Detektoreinheit 33_{b}.

Die Steuervorrichtung 30 oder die jeweilige der n Signalleitungsdetektoreinrichtungen 31₁, 31₂ ist bei Detektion eines AISG-Signals an der jeweiligen Signalanschlusskontaktierung 19₁, 19₂ dazu ausgebildet, die erste Schalteinheit 32₁ₐ bzw. 31₂ₐ in der jeweiligen Umgehungsleitung 20₁, 20₂ derart anzusteuern, dass diese diejenige der n Signalleitungsanschlusskontaktierungen 19₁, 19₂, an welcher das AISG-Signal detektiert wurde, mit der Common-Anschlusskontaktierung 18 elektrisch verbindet. Diese Verbindung erfolgt bevorzugt niederohmig. Dies geschieht bevorzugt nur im BTS-Betriebszustand.

Die Elektronikeinrichtung 2 weist außerdem einen Common-Signalsplitter 35 und n Anschluss-Signalsplitter 36₁, 36₂, ..., 36ₙ auf. Der Common-Signalsplitter 35 und die n Anschluss-Signalsplitter 36₁, 36₂, ..., 36ₙ umfassen jeweils einen ersten, einen zweiten und einen dritten Anschluss. Sie sind dazu ausgebildet, ein Mischsignal (überlagertes Signal) aus einem DC-Signal und einem AISG-Signal, welches an dem ersten Anschluss anliegt, aufzuteilen und das DC-Signal an dem zweiten Anschluss und das AISG-Signal an dem dritten Anschluss auszugeben. Sie sind weiterhin dazu ausgebildet, ein DC-Signal, das an dem zweiten Anschluss anliegt und ein AISG-Signal, das an dem dritten Anschluss anliegt, zusammenzufassen und als Mischsignal an den ersten Anschluss auszugeben.

Der Common-Signalsplitter 35 ist mit seinem ersten Anschluss mit der Common-Anschlusskontaktierung 18 elektrisch verbunden. Jeder der n Anschluss-Signalsplitter 36₁, 36₂, ..., 36ₙ ist mit seinem ersten Anschluss mit der jeweiligen Signalleitungsanschlusskontaktierung 19₁, 19₂, ..., 19ₙ verbunden, wodurch jede der n Umgehungsleitungen 20₁, 20₂, ..., 20ₙ in ein AISG-Leitungssegment 20₁ₐ, 20₂ₐ, ..., 20ₙₐ und in ein DC-Leitungssegment 20_{1b}, 20_{2b}, ..., 20_{nb} aufgeteilt ist. Die jeweiligen zweiten Anschlüsse der n Anschluss-Signalsplitter 36₁, 36₂ sind elektrisch miteinander und mit dem zweiten Anschluss des Common-Signalsplitters 35 verbunden. Diese Verbindung ist ebenfalls niederohmig. Selbiges gilt auch für die dritten Anschlüsse der n Anschluss-Signalsplitter 36₁, 36₂. Diese sind ebenfalls elektrisch miteinander und mit dem dritten Anschluss des Common-Signalsplitters 35 verbunden. Diese Verbindung ist ebenfalls niederohmig. Daher sind einerseits alle AISG-Leitungssegmente 20₁ₐ, 20₂ₐ und andererseits alle DC-Leitungssegmente 20_{1b}, 20_{2b} elektrisch miteinander verbunden.

Der Common-Signalsplitter 35 und die Anschluss-Signalsplitter 36₁, 36₂ können auch als Frequenzweichen bezeichnet werden, die ein entsprechendes Mischsignal aufgrund der vorhandenen Frequenzen aufteilen und an den zweiten bzw. dritten Anschlüssen entsprechend ausgeben.

In dem dargestellten Ausführungsbeispiel ist in jedem der AISG-Leitungssegmente 20₁ₐ, 20₂ₐ die erste Schalteinheit 32₁ₐ, 32₂ₐ der jeweiligen Signalleitungs-Schalteinrichtung 32₁, 32₂ angeordnet. Bei Betätigung dieser ersten Schalteinheit 32₁ₐ, 32₂ₐ wird das jeweilige AISG-Leitungssegment 20₁ₐ, 20₂ₐ unterbrochen oder durchgeschaltet.

In Figur 1 ist ebenfalls dargestellt, dass die n Signalleitungs-Schalteinrichtungen 32₁, 32₂ jeweils zumindest eine zweite Schalteinheit 32_{1b}, 32_{2b}, ... 32_{nb} umfassen. In jedem DC-Leitungssegment 20_{1b}, 20_{2b} ist jeweils eine zweite Schalteinheit 32_{1b}, 32_{2b} einer der n Signalleitungs-Schalteinrichtungen 32₁, 32₂ angeordnet. Bei Betätigung der zweiten Schalteinheit 32_{1b}, 32_{2b} wird das entsprechende DC-Leitungssegment 20_{1b}, 20_{2b} unterbrochen bzw. durchgeschaltet.

Sowohl die erste Schalteinheit 32₁ₐ, 32₂ₐ als auch die zweite Schalteinheit 32_{1b}, 32_{2b} ist insbesondere durch ein Relais gebildet. Dabei werden vorzugsweise bistabile Relais eingesetzt. Diese behalten ihren Schaltzustand auch dann bei, wenn sie nicht mit einer Spannung beaufschlagt werden. Dadurch wird der Stromverbrauch des HF-Combiners 1 für die Elektronikeinrichtung 2 gesenkt. Halbleiterelemente wie z. B. CMOS-Schalter, Triacs, einer Anordnung aus zwei MOSFETs oder Mikroschalter könnten auch verwendet werden. Allerdings werden Relais aufgrund des besseren Blitzschutzes bevorzugt.

Die Common-Detektoreinrichtung 33 ist vorzugsweise an der Common-Anschlusskontaktierung 18 angeschlossen oder angekoppelt. Sie könnte auch zwischen dem Common-Anschluss 8 und den n Signalleitungs-Schalteinrichtungen 32₁, 32₂ oder dem Common-Signalsplitter 35 angeschlossen oder angekoppelt sein.

Zur Messung eines Kurzschlusses wird insbesondere ein Shuntwiderstand verwendet. Zur Messung eines DC-Signals und/oder eines AISG-Signals kann eine Auskopplung, insbesondere mittels eines Spannungsteilers verwendet werden.

Die Signalleitungs-Detektoreinrichtungen 31₁, 31₂ können ein DC-Signal an der jeweiligen Signalleitungsanschluss-Kontaktierung 19₁, 19₂ detektieren. Dies geschieht insbesondere über die jeweilige DC-Detektoreinheit 31_{1b}, 31_{2b}. Die Common-Detektoreinrichtung 33 ist ebenfalls dazu ausgebildet, zu detektieren, ob an der Common-Anschlusskontaktierung 18 ein DC-Signal anliegt. Dies gelingt wiederum über die DC-Detektoreinheit 33a. Sowohl die Common-Detektoreinrichtung 33 als auch die jeweilige SignalleitungsDetektoreinrichtung 31₁, 31₂ übermitteln ihre Messergebnisse in Form von analogen oder digitalen Werten an die Steuervorrichtung 30.

Beim Starten der Steuervorrichtung 30 nimmt diese einen Startbetriebszustand ein. Von dort aus wechselt sie in den BTS-Betriebszustand über, wenn eine der Signalleitungsdetektoreinrichtungen 31₁, 31₂ ein DC-Signal an einer der Signalleitungsanschlusskontaktierungen 19₁, 19₂ detektiert. Dies ist ein Indiz dafür, dass der HF-Combiner 1 von der jeweiligen Basisstation 50ₐ, 50_{b}, ... 50ₙ mit Strom versorgt wird.

Weiterhin ist die Steuervorrichtung 30 dazu ausgebildet, von dem Startbetriebszustand in einen ANT-Betriebszustand zu wechseln. Dies geschieht dann, wenn die Common-Detektoreinrichtung 33 ein DC-Signal an der Common-Anschlusskontaktierung 18 detektiert. In diesem Fall ist davon auszugehen, dass der HF-Combiner 1 über den Common-Anschluss 8 mit elektrischer Energie versorgt wird, was ein Hinweis darauf ist, dass der HF-Combiner 1 auf dem Antennenmast angeordnet ist und nicht bei den Basisstationen 50ₐ, 50_{b}.

Die Steuervorrichtung 30 ist im Startbetriebszustand insbesondere dazu ausgebildet, die n Signalleitungs-Schalteinrichtungen 32₁, 32₂ derart anzusteuern, dass die n Umgehungsleitungen 20₁, 20₂ unterbrochen werden, wodurch die n Signalleitungsanschlusskontaktierungen 19₁, 19₂ elektrisch von der Common-Anschlusskontaktierung 18 getrennt sind. In diesem Fall kann besonders einfach detektiert werden, ob an der Common-Anschlusskontaktierung 18 oder an einer der Signalleitungsanschlusskontaktierungen 19₁, 19₂ ein DC-Signal anliegt, um den passenden Betriebszustand auszuwählen.

Die Steuervorrichtung 30 ist im BTS-Betriebszustand dazu ausgebildet, diejenige der n Signalleitungsanschlusskontaktierungen 19₁, 19₂, an welcher ein DC-Signal als erstes detektiert wurde, durch Ansteuern der entsprechenden Signalleitungsschalteinrichtung 32₁, 32₂ mit der Common-Anschlusskontaktierung 18 elektrisch zu verbinden. Dabei ist die Steuereinrichtung 30 weiter dazu ausgebildet, die anderen Signalleitungsanschlusskontaktierungen 19₁, 19₂, an denen ein DC-Signal erst später überhaupt nicht detektiert wurde, durch Ansteuern der entsprechenden Signalleitungsschalteinrichtungen 32₁, 32₂ von der Common-Anschlusskontaktierung 18 elektrisch zu trennen. Dadurch wird vermieden, dass aufgrund von Potenzialunterschieden ein Stromfluss zwischen den einzelnen Signalanschlusskontaktierungen 19₁, 19₂ stattfindet, wodurch die Basisstationen 50ₐ, 50_{b} beschädigt werden könnten. Bevorzugt wird in diesem Fall lediglich die zweite Schalteinheit 32_{1b}, 32_{2b} der entsprechenden Signalleitungs-Schalteinrichtungen 32₁, 32₂ betätigt. Dadurch wird die entsprechende Signalleitungsanschlusskontaktierung 19₁, 19₂ lediglich über das jeweilige DC-Leitungssegment 20_{1b}, 20_{2b} mit der Common-Anschlusskontaktierung 18 elektrisch verbunden.

Im BTS-Betriebszustand ist die Steuervorrichtung 30 insbesondere auch dazu ausgebildet, dass für den Fall, dass ein AISG-Signal an einer der n Signalleitungsanschlusskontaktierungen 19₁, 19₂ detektiert wird, die entsprechende Signalleitungsschalteinrichtung 32₁, 32₂ durch die Steuervorrichtung 30 angesteuert wird, dass diese die jeweilige Signalleitungsanschlusskontaktierung 19₁, 19₂ mit der Common-Anschlusskontaktierung 18 elektrisch verbindet, so dass das AISG-Signal auch an der Common-Anschlusskontaktierung 18 anliegt. Hierbei wird insbesondere lediglich die entsprechende erste Schalteinheit 32₁ₐ, 32₂ₐ betätigt. In diesem Fall ist es möglich, dass ein DC-Signal von einer ersten Signalleitungsanschlusskontaktierung 19₁ an die Common-Anschlusskontaktierung 18 zugeführt wird, wohingegen ein AISG-Signal von einer zweiten Signalleitungsanschlusskontaktierung 19₂ an die Common-Anschlusskontaktierung 18 übertragen wird.

Für den Fall allerdings, dass an einer einzigen Signalleitungsanschlusskontaktierung 19₁, 19₂ sowohl ein AISG-Signal als auch ein DC-Signal detektiert werden, ist die Steuervorrichtung 30 bzw. auch die entsprechende Signalleitungs-Detektoreinrichtung 31₁, 31₂ direkt in der Lage, die entsprechende Signalleitungsschalteinrichtung 32₁, 32₂ derart anzusteuern, dass diese die entsprechende Signalleitungsanschlusskontaktierung 19₁, 19₂ (an welcher das AISG-Signal und das DC-Signal anliegen) elektrisch mit der Common-Anschlusskontaktierung 18 verbindet. Diese Verbindung ist niederohmig. Dabei ist die Steuervorrichtung 30 auch in der Lage, alle anderen aktivierten Signalleitungsschalteinrichtungen 32₁, 32₂ derart anzusteuern, dass diese eine elektrische Verbindung zwischen ihren jeweiligen Signalleitungsanschlusskontaktierungen 19₁, 19₂ und der Common-Anschlusskontaktierung 18 trennen.

Ein solches Umschalten erfolgt insbesondere unterbrechungsfrei. An der Common-Anschlusskontaktierung 18 liegt daher immer ein DC-Signal an. In den Figuren 2A bis 2D wird ein Schaltungsteil der Elektronikeinrichtung 2 beschrieben, durch die ein solches unterbrechungsfreies Umschalten erreicht werden kann.

In Figur 2A ist gezeigt, dass an der ersten Signalleitungsanschlusskontaktierung 19₁ ein DC-Signal anliegt. Dieses wurde detektiert und im Folgenden die zweite Schalteinheit 32_{1b} entsprechend angesteuert, dass diese eine elektrische Verbindung zwischen der ersten Signalleitungsanschlusskontaktierung 19₁ und der Common-Anschlusskontaktierung 18 herstellt. Die Anschluss-Signalsplitter 36₁, 36₂ bzw. der Common-Signalsplitter 35 sind nur über die gepunktete Leiterbahn angedeutet. Die Elektronikeinrichtung 2, also der HF-Combiner 1 umfasst hier noch n Signalleitungsanschlussdioden 37₁, 37₂, ..., 37ₙ, wobei jede der n Signalleitungsanschlussdioden 37₁, 37₂, ..., 37ₙ mit ihrer Anode mit dem jeweiligen DC-Leitungssegment 20_{1b}, 20_{2b}, ..., 20_{nb} zwischen der jeweiligen Signalleitungsanschlusskontaktierung 19₁, 19₂, ..., 19ₙ bzw. dem jeweiligen Anschluss-Signalsplitter 36₁, 36₂, ..., 36ₙ und der jeweiligen zweiten Schalteinheit 32_{1b}, 32_{2b}, ..., 32_{nb} elektrisch verbunden ist. Die Signalleitungsanschlussdioden 37₁, 37₂, ..., 37ₙ sind mit ihrer Kathode dagegen miteinander elektrisch verbunden. Weiterhin ist noch eine Common-Anschlussdiode 38 vorgesehen, die mit ihrer Anode mit den, miteinander elektrisch verbundenen, DC-Leitungssegmenten 20_{1b}, 20_{2b}, ..., 20_{nb} am Ausgang der jeweiligen zweiten Schalteinheit 32_{1b}, 32_{2b}, ..., 32_{nb} verbunden ist. Die Kathode der Common-Anschlussdiode 38 ist direkt mit der Common-Anschlusskontaktierung 18 verbunden oder indirekt. Eine indirekte Verbindung liegt dann vor, wenn die Kathode der Common-Anschlussdiode 38 beispielsweise mit dem zweiten Anschluss des Common-Signalsplitters 35 elektrisch verbunden ist.

Weiterhin ist noch ein Wechselschalter 39 vorgesehen. Dieser umfasst zumindest einen ersten Anschluss, der elektrisch mit der Kathode der Common-Anschlussdiode 38 verbunden ist. Ein zweiter Anschluss ist mit der Anode der Common-Anschlussdiode 38 verbunden. An diesem zweiten Anschluss sind alle DC-Leitungssegment 20_{1b}, 20_{2b}, ..., 20_{nb} zusammengeführt. Ein dritter Anschluss des Wechselschalters 39 ist mit den Kathoden aller Signalleitungsanschlussdioden 37₁, 37₂, ..., 37ₙ elektrisch verbunden.

In einem ersten Schaltzustand des Wechselschalters 39 verbindet dieser seinen ersten Anschluss mit seinem zweiten Anschluss. Dieser Sachverhalt ist in Figur 2A gezeigt. Dieser erste Schaltzustand wird insbesondere dann eingenommen, wenn an einer Signalleitungsanschlusskontaktierung 19₁, 19₂, ..., 19ₙ ein DC-Signal detektiert wurde und dieses DC-Signal durch Ansteuerung der jeweiligen zweiten Schalteinheit 32_{1b}, 32_{2b}, ..., 32_{nb} auf die Common-Anschlusskontaktierung 18 geschaltet wird. Aufgrund des höheren Widerstands der Common-Anschlussdiode 38 fließt der meiste Strom über den Wechselschalter 39.

Werden im Folgenden ein DC-Signal und ein AISG-Signal an einer anderen Signalleitungsanschlusskontaktierung 19₁, 19₂, ..., 19ₙ detektiert (hier an der zweiten Signalleitungsanschlusskontaktierung 19₂₎, dann soll neben dem AISG-Signal bevorzugt auch das DC-Signal zu der Common-Anschlusskontaktierung 18 unterbrechungsfrei durchgeschalten werden. Allerdings muss vermieden werden, dass ein Stromfluss zwischen zwei Signalleitungsanschlusskontaktierung 19₁, 19₂, ..., 19ₙ stattfinden kann, weil ansonsten die jeweiligen Basisstationen 50ₐ, 50_{b} kurzgeschlossen werden. In diesem Fall soll statt dem DC-Signal von der ersten Signalleitungsanschlusskontaktierung 19₁ nur das DC-Signal von der zweiten Signalleitungsanschlusskontaktierung 19₂ zu der Common-Anschlusskontaktierung 18 durchgeschalten werden. Um einen solchen Wechsel zu erreichen nimmt der Wechselschalter 39 einen zweiten Schaltzustand ein. In diesem zweiten Schaltzustand verbindet dieser seinen ersten Anschluss mit seinem dritten Anschluss (Siehe Figur 2B).

In diesem Fall erfolgt der Stromfluss einerseits durch die Common-Anschlussdiode 38 und die zweite Schalteinheit 32_{1b} der ersten Signalleitungs-Schalteinrichtung 32₁ und andererseits durch die erste und zweite Signalleitungsanschlussdiode 37₁, 37₂. Es wäre auch möglich, dass der Wechselschalter 39 einen Zwischenschaltzustand einnimmt und in diesem Zwischenschaltzustand seinen ersten Anschluss weder mit seinem zweiten Anschluss noch mit seinem dritten Anschluss verbindet. In diesem Fall würde der Stromfluss lediglich über die Common-Anschlussdiode 38 erfolgen. Ein direkter Stromfluss zwischen den Signalleitungsanschlusskontaktierungen 19₁, 19₂ ist aufgrund der Signalleitungsanschlussdioden 37₁, 37₂ nicht möglich. Die zweite Schalteinheit 32_{2b} der zweiten Signalleitungs-Schalteinrichtung 32₂ ist hier noch geöffnet. Nach dem Zwischenschaltzustand geht der Wechselschalter 39 in seinen zweiten Schaltzustand über.

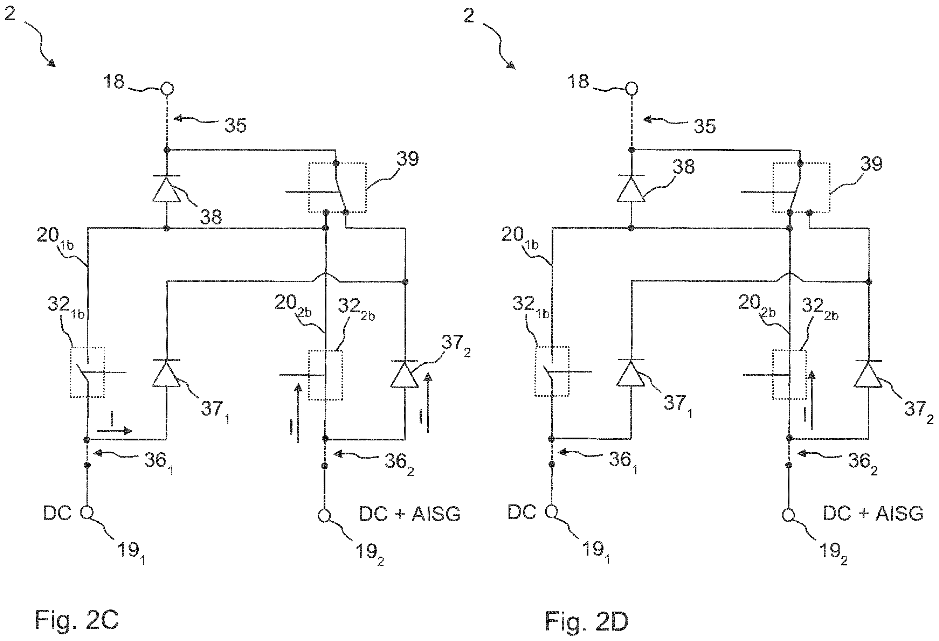

Sobald der Wechselschalter 39 seinen zweiten Schaltzustand eingenommen hat, kann die zweite Schalteinheit 32_{1b} der ersten Signalleitungs-Schalteinrichtung 32₁ geöffnet werden. In diesem Fall findet die Übertragung des DC-Signals lediglich über die beiden Signalleitungsanschlussdioden 37₁, 37₂ und den Wechselschalter 39 statt. Nachdem die zweite Schalteinheit 32_{1b} der ersten Signalleitungs-Schalteinrichtung 32₁ geöffnet wurde, kann die zweite Schalteinheit 32_{2b} der zweiten Signalleitungs-Schalteinrichtung 32₂ geschlossen werden. Dieser Zustand ist in Figur 2C dargestellt. Ein DC-Signal fließt zusätzlich über die zweite Schalteinheit 32_{2b} der zweiten Signalleitungs-Schalteinrichtung 32₂ und die Common-Anschlussdiode 38.

Im Anschluss daran nimmt der Wechselschalter 39 wieder seinen ersten Schaltzustand ein (siehe Figur 2D). Die Übertragung des DC-Signals erfolgt in diesem Schaltzustand wieder überwiegend über den Wechselschalter 39 und die zweite Schalteinheit 32_{2b} der zweiten Signalleitungs-Schalteinrichtung 32₂. Die Steuerung des Wechselschalters 39 erfolgt bevorzugt über die Steuervorrichtung 30. Bei dem Wechselschalter 39 handelt es sich insbesondere um ein Relais. Vorzugsweise um ein Single-Pole/Double-Throw-Relais.

Grundsätzlich gilt insbesondere, dass zu keinen Zeitpunkt (im BTS-Betriebszustand) mehr als eine zweite Schalteinheit 32_{1b}, 32_{2b}, ..., 32_{nb} geschlossen ist (insbesondere wenn an den entsprechenden Signalleitungsanschlusskontaktierungen 19₁, 19₂, ..., 19ₙ ein DC-Signal detektiert wurde). Im ANT-Betriebszustand ist dies natürlich anders. Selbiges kann im BTS-Betriebszustand auch für die ersten Schalteinheiten 32₁ₐ, 32₂ₐ, ..., 32ₙₐ gelten.

In diesem Fall werden das AISG-Signal und das DC-Signal lediglich von einer einzigen Signalleitungsanschlusskontaktierung 19₁, 19₂ zur Common-Anschlusskontaktierung 18 übertragen. Die Steuervorrichtung 30 bzw. die entsprechende Signalleitungsdetektoreinrichtung 31₁, 31₂ steuern dabei sowohl die erste Schalteinheit 32₁ₐ, 32₂ₐ als auch die zweite Schalteinheit 32_{1b}, 32_{2b} der entsprechenden Signalleitungs-Schalteinrichtung 32₁, 32₂ an. Dadurch wird verhindert, dass die Basisstation 50ₐ, 50_{b}, die beispielsweise zuerst gestartet wurde, für die gesamte Spannungsversorgung aller elektrischen Funktionseinheiten auf dem Antennenmast zuständig ist. Erfindungsgemäß versorgt in diesem Fall jede Basisstation 50ₐ, 50_{B} nur einen Teil der elektrischen Funktionseinheiten.

Für den Fall, dass an zwei Signalleitungsanschlusskontaktierungen 19₁, 19₂ ein AISG-Signal detektiert wird, werden die entsprechenden Signalleitungs-Schalteinrichtung 32₁, 32₂ vorzugsweise derart angesteuert, dass diese die entsprechenden Signalleitungsanschlusskontaktierungen 19₁, 19₂ zumindest für das AISG-Signal und bevorzugt ebenfalls für das DC-Signal von der Common-Anschlusskontaktierung 18 trennen. In diesem Fall würde kein AISG-Signal an der Common-Anschlusskontaktierung 18 anliegen.

Die Common-Detektoreinrichtung 33 ist vorzugsweise auch dazu ausgebildet zu detektieren, ob an der Common-Anschlusskontaktierung 18 ein Kurzschluss vorliegt. In diesem Fall ist die Steuervorrichtung 30 dazu ausgebildet, die entsprechende Signalleitungsanschlusskontaktierung 19₁, 19₂ nur dann mit der Common-Anschlusskontaktierung 18 zu verbinden, wenn durch die Common-Detektoreinrichtung 33 kein Kurzschluss detektiert wurde. Dies gilt insbesondere für die jeweilige erste und zweite Schalteinheit 32₁ₐ, 32₂ₐ, 31_{1b}, 32_{2b}. Ein solcher Kurzschluss kann beispielsweise dann auftreten, wenn an den Signalleitungsanschlusskontaktierung 19₁, 19₂ des antennenseitigen HF-Combiners 1 direkt Antennenelemente 54 angeschlossen sind.

Auch die Signalleitungsdetektoreinrichtungen 31₁, 31₂ sind dazu ausgebildet, einen Kurzschluss an ihren jeweiligen Signalleitungsanschlusskontaktierungen 19₁, 19₂ zu detektieren. Die Steuervorrichtung 30 ist dann im ANT-Betriebszustand dazu ausgebildet, die Common-Anschlusskontaktierung 18 lediglich mit denjenigen der n Signalleitungsanschlusskontaktierungen 19₁, 19₂ elektrisch zu verbinden, an denen kein Kurzschluss detektiert wurde. Bei den anderen Signalleitungsanschlusskontaktierungen 19₁, 19₂ wird die Verbindung durch Ansteuern der entsprechenden Signalleitungsschalteinrichtungen 32₁, 32₂ unterbrochen.

Für den Fall, dass die Steuervorrichtung 30 im ANT-Betriebszustand ist, können sowohl die ersten als auch die zweiten Schalteinheiten 32₁ₐ, 33₂ₐ, 32_{1b}, 32_{2b} derart angesteuert werden, dass die Common-Anschlusskontaktierung 18 mit allen nicht kurzschlussbehafteten Signalleitungsanschlusskontaktierungen 19₁, 19₂ verbunden ist. In diesem Fall wird ein AISG-Signal, welches an der Common-Anschlusskontaktierung 18 anliegt, an allen Signalleitungsanschlusskontaktierungen 19₁, 19₂ ausgegeben. Dies ist kein Problem, weil das AISG-Protokoll eine Adressierung der einzelnen AISG-fähigen elektrischen Funktionseinheiten zulässt. Dagegen können die zweiten Schalteinheiten 32_{1b}, 32_{2b} alle eine elektrische Verbindung zu den nicht mit einem Kurzschluss behafteten Signalleitungsanschlusskontaktierungen 19₁, 19₂ herstellen, wodurch an diese ein DC-Signal übertragen werden kann.

Die Steuervorrichtung 30 ist sowohl im BTS-Betriebszustand als auch im ANT-Betriebszustand dazu ausgebildet, einen Pegel für die DC-Signale an der Common-Anschlusskontaktierung 18 und/oder den jeweiligen Signalleitungsanschlusskontaktierungen 19₁, 19₂ zu überwachen. Fällt der Pegel unterhalb eines bestimmten einstellbaren Schwellwerts (z. B. unter 35 V, 30 V, 25 V, 20 V, 15 V, 10 V) ab, dann werden die entsprechenden oder alle der Signalleitungsschalteinrichtungen 32₁, 32₂ derart angesteuert, dass diese die elektrische Verbindung unterbrechen. Dies ist insbesondere dann sinnvoll, wenn die entsprechenden Basisstationen 50a, 50b ausgeschaltet werden. Dadurch sind bei einem Neustart der Basisstation 50a, 50b die Signalleitungsschalteinrichtungen 32₁, 32₂ derart eingestellt, dass die elektrische Verbindung zwischen der Common-Anschlusskontaktierung 18 und den n Signalleitungsanschlusskontaktierungen 19₁, 19₂ unterbrochen ist (s. bistabile Relais).

Die in Figur 1 dargestellte Elektronikeinrichtung 2 ist vorzugsweise auf der Leiterplattenanordnung 11 angeordnet.

Wie bereits erläutert, ist die Steuervorrichtung 30 im BTS-Betriebszustand dazu ausgebildet, bei der Detektion eines AISG-Signals an einer der n Signalleitungsanschlusskontaktierungen 19₁, 19₂ dieses durch Ansteuern der entsprechenden Signalleitungsschalteinrichtungen 32₁, 32₂ an die Common-Anschlusskontaktierung 18 zu übertragen bzw. durchzuschalten. Dies geschieht allerdings bevorzugt so schnell, dass bereits das erste Bit, also insbesondere der erste On/Off-Keying-Impuls des als On/Off-Keying-Signals ausgebildeten AISG-Signals noch zu mehr als 70%, 80%, 90% an die Common-Anschlusskontaktierung 18 übertragbar ist. Anstelle von einem On/Off-Keying-Impuls kann auch von einem On/Off-Keying-Burst gesprochen werden. Dann ist nämlich die entsprechende elektrische Funktionseinheit noch in der Lage, den durch das AISG-Signal übertragenen Befehl vollständig zu erfassen und im Anschluss daran umzusetzen. Die entsprechende Signalleitungsdetektoreinrichtung 31₁, 31₂ und in dieser die AISG-Detektoreinheit 31₁ₐ bzw. 31₂ₐ kann beispielsweise einen Komparator umfassen, dessen Schwelle derart gelegt ist, dass der Signalpegel des On/Off-Keying-Signals sicher erfasst wird und bei Überschreiten dieser Schwelle in einem sehr kurzen Zeitraum eine Änderung des Signalpegels an dem Komparatorausgang stattfindet. Diese Änderung kann dann durch die Steuervorrichtung 30 detektiert werden. Die Ansteuerung der entsprechenden Signalleitungsschalteinrichtung 32₁, 32₂ bzw. der ersten Schalteinheit 32₁ₐ, 32₂ₐ kann in diesem Fall auch direkt durch die jeweilige AISG-Detektoreinheit 31₁ₐ bzw. 31₂ₐ erfolgen.

In Figur 1 geben die Pfeile bevorzugt die Richtung an, in welcher Informationen bzw. Schaltimpulse von und zu der Steuervorrichtung 30 übertragen werden. Grundsätzlich wäre eine Informationsübertragung in jeweils beiden Richtungen auch denkbar.

Figur 4A zeigt einen beispielhaften Aufbau der erfindungsgemäßen HF-Combineranordnung 3. Diese umfasst einen ersten und einen zweiten HF-Combiner 1ₐ, 1_{b}, die wie eingangs beschrieben aufgebaut sein können. Lediglich der in Figur 3B dargestellte Gehäusedeckel 10 ist nicht notwendig. Die entsprechenden Aufnahmeräume 15 des ersten HF-Combiners 1ₐ werden durch die Leiterplattenanordnung 11 von dem Aufnahmeraum 15 des zweiten HF-Combiners 1_{b} elektrisch bzw. elektromagnetisch getrennt. Die Leiterplattenanordnung 11 ist in Figur 4A zwischen den HF-Combinern 1ₐ und 1_{b} dargestellt. Der erste und der zweite HF-Combiner 1ₐ, 1_{b} sind umgekehrt aufeinandergesetzt, so dass sich die jeweiligen Aufnahmeräume 15 gegenüberstehen.

Die Leiterplattenanordnungen 11 des ersten und zweiten HF-Combiners 1ₐ, 1_{b} umfassen jeweils eine Leiterplatte 11ₐ, 11_{b}. Die jeweilige Elektronikeinrichtung 2 des ersten und des zweiten HF-Combiners 1ₐ, 1_{b} sind dabei nur auf einer ersten Seite der jeweiligen Leiterplatte 11ₐ, 11_{b} angeordnet. Die ersten Seiten der Leiterplatten 11ₐ, 11_{b} stehen sich dabei gegenüber, wobei eine zweite Seite der jeweiligen Leiterplatte 11ₐ, 11_{b} mit einer Metallschicht beschichtet ist. Die jeweilige Elektronikeinrichtung 2 ist daher in einem Abstandsraum 40 zwischen den beiden Leiterplatten 11ₐ, 11_{b} angeordnet. Grundsätzlich können die beiden Leiterplatten 11ₐ, 11_{b}, wie später noch erläutert, innerhalb der umlaufenden Gehäusewand 7 des jeweiligen HF-Combiners 1ₐ, 1_{b} angeordnet sein. Sie können allerdings auch auf der Stirnseite 41 der umlaufenden Gehäusewand 7 des jeweiligen HF-Combiners 1ₐ, 1_{b} aufliegen, wobei der Abstandsraum 40 vorzugsweise durch ein Gehäuse umgrenzt ist, welches das Einkoppeln von Störstrahlern von außerhalb der HF-Combineranordnung 3 verhindert.

In den Figuren 4B und 4C wird ein weiteres Ausführungsbeispiel der erfindungsgemäßen HF-Combineranordnung 3 beschrieben. Diese Figuren zeigen einen Schnitt durch den ersten und zweiten HF-Combiner 1ₐ, 1_{b}, wobei nur die geschnittenen Teile dargestellt sind (z. B. fehlt der nicht geschnittene Common-Anschluss 8 des ersten HF-Combiners 1ₐ). Die Leiterplattenanordnung 11 des ersten und zweiten HF-Combiners 1ₐ, 1_{b} weist eine gemeinsame Leiterplatte 11 auf bzw. ist als gemeinsame Leiterplatte 11 ausgebildet. Auf dieser gemeinsamen Leiterplatte 11 sind die Elektronikeinrichtung 2 des ersten HF-Combiners 1ₐ und die Elektronikeinrichtung 2 des zweiten HF-Combiners 1_{b} auf einer ersten Seite 11₁ angeordnet. Die gegenüberliegende zweite Seite 11₂ der gemeinsamen Leiterplatte 11 ist vorzugsweise mit einer Metallschicht versehen. Die gemeinsame Leiterplatte 11 weist die Common-Anschlusskontaktierung 18 und die Signalleitungsanschlusskontaktierungen 19₁, 19₂ des ersten und des zweiten HF-Combiners 1ₐ, 1_{b} auf. Zwischen der ersten Seite 11₁ der gemeinsamen Leiterplatte 11 und dem ersten HF-Combiner 1ₐ ist noch ein Abschirmdeckel 42 angeordnet, so dass die erste Seite 11₁ der gemeinsamen Leiterplatte 11 von dem Aufnahmeraum 15 des ersten HF-Combiners 1ₐ elektrisch oder elektromagnetisch getrennt bzw. entkoppelt ist. Es wäre auch möglich, dass zwischen der zweiten Seite 112 der gemeinsamen Leiterplatte 11 und dem zweiten HF-Combiner 1_{b} ebenfalls noch ein weiterer Abschirmdeckel angeordnet ist.

In Figur 4C ist die HF-Combineranordnung 3 in einem zusammengebauten Zustand dargestellt.

Das Verbinden, insbesondere das Anlöten der Tiefpässe 17 an die gemeinsame Leiterplatte 11 erfolgt insbesondere im auseinandergebauten Zustand. Grundsätzlich kann hierfür ein entsprechendes Anschlusskabel entsprechend länger sein als dies in den Zeichnungsfiguren 4B und 4C dargestellt ist. Die Lötstelle auf der gemeinsamen Leiterplatte 11 wird auch als Signalleitungsanschlusskontaktierung 19₁, 19₂ bzw. als Common-Anschlusskontaktierung 18 bezeichnet.

Die umlaufende Gehäusewand 7 des ersten HF-Combiners 1ₐ umfasst die Stirnseite 41, wobei ein Teil der Stirnseite 41, der an den Aufnahmeraum 15 angrenzt, in Richtung des Gehäusebodens 6 versetzt ist, wodurch eine erste Auflageschulter 43 gebildet ist. Selbiges gilt auch für die umlaufende Gehäusewand 41 des zweiten HF-Combiners 11b. Die gemeinsame Leiterplatte 11 liegt dabei auf der zweiten Auflageschulter 43 des zweiten HF-Combiners 1b auf und der Abschirmdeckel 42 liegt auf der ersten Auflageschulter 43 des ersten HF-Combiners 1ₐ auf.

Für den Fall, das zwei getrennte Leiterplatten 11ₐ, 11_{b} verwendet werden (s. Figur 4A), liegt die Leiterplatte 11ₐ des ersten HF-Combiners 1ₐ auf der ersten Auflageschulter 43 des ersten HF-Combiners 1ₐ auf und die Leiterplatte 11_{b} des zweiten HF-Combiners 1_{b} auf der zweiten Auflageschulter 43 des zweiten HF-Combiners 1_{b}.

Mit anderen Worten weist die jeweilige umlaufende Gehäusewand 7 des ersten bzw. zweiten HF-Combiners 1ₐ, 1_{b} eine treppen- oder schulterförmige Ausnehmung an dem Teil der umlaufenden Gehäusewand 7 auf, die an den jeweiligen Aufnahmeraum 15 angrenzt.

Vorzugsweise ist an der umlaufenden Gehäusewand 7 des ersten und des zweiten HF-Combiners 11ₐ, 11_{b} im Bereich der jeweiligen Stirnseite 41 noch ein flanschförmiger Vorsprung 44 ausgebildet. Die flanschförmigen Vorsprünge 44, die nach außerhalb des Gehäuses 5 abstehen, kommen im zusammengebauten Zustand der HF-Combineranordnung 3 übereinander zu liegen, so dass über eine Schraubverbindung 45 eine Fixierung der beiden HF-Combiner 1ₐ, 1_{b} aneinander erfolgt. Diese Verbindung ist dabei hochfrequenzdicht. Grundsätzlich könnte hier noch ein zusätzliches Dichtelement eingebracht werden.

Die erfindungsgemäße HF-Combineranordnung 3 beinhaltet aufgrund des Aufbaus aus zwei HF-Combinern 1ₐ, 1_{b} auch einen eigenständigen erfinderischen Gedanken, wonach auf die Elektronikeinrichtung 2, wie sie im Zusammenhang des jeweiligen HF-Combiners 1ₐ, 1_{b} beschrieben wurde, verzichtet wird. Dieser erfinderische Gedanke ist in den Ansprüchen 18 und 19 eigenständig beschrieben, wobei sich in diesem Fall der Anspruch 18 nicht mehr auf den Anspruch 1 rückbeziehen müsste. Auf der jeweiligen Leiterplattenanordnung 11 (bzw. der gemeinsamen Leiterplatte 11) wären lediglich die einzelnen Umgehungsleitungen 20₁, 20₂ von der jeweiligen Signalleitungsanschlusskontaktierung 19₁, 19₂ hin zu Common-Anschlusskontaktierungen 18 angeordnet. Die entsprechende Elektronikeinrichtung 2 wäre hierfür nicht notwendig. Die Verbindung könnte dann statisch sein.

Figur 5 zeigt ein weiteres Ausführungsbeispiel, das eine erfindungsgemäße Mobilfunk-Site 4 näher beschreibt. Die Mobilfunk-Site 4 umfasst zwei HF-Combiner 1, 1ₐ, 1_{b} wie sie beispielsweise in den Figuren 1, 3A und 3B beschrieben wurden. Es wäre auch möglich, dass die Mobilfunk-Side 4 zumindest eine erste HF-Combineranordnung 3, 3ₐ umfasst, wie diese in den Figuren 4A, 4B oder 4C beschrieben wurde.

Es sind dabei n Basisstationen 50ₐ, 50_{b}, ... 50ₙ vorgesehen, wobei die n Basisstation 50ₐ, 50_{b} in unterschiedlichen Mobilfunkbändern (z.B. 2100 MHz, 1800 MHz) betreibbar sind. In Figur 5 ist dargestellt, dass auch unterschiedliche Mobilfunkstandards (UMTS und LTE) von den Basisstationen 50ₐ, 50_{b} verwendet werden.

Jede der n Basisstationen 50ₐ, 50_{b} hat zwei Signalanschlüsse 50ₐ₁, 50ₐ₂, 50_{b1}, 50_{b2}, wobei die Basisstationen 50ₐ, 50_{b} dazu ausgebildet sind, an dem ersten Signalanschluss 50ₐ₁, 50_{b1} ein MAIN-Signal auszusenden und/oder zu empfangen und wobei die Basisstationen 50ₐ, 50_{b} weiterhin dazu ausgebildet sind, an dem zweiten Signalanschluss 50ₐ₂, 50_{b2} ein DIV-Signal auszusenden und/oder zu empfangen.

Die ersten Signalanschlüsse 50ₐ₁, 50_{b1} der Basisstation 50ₐ, 50_{b} sind mit den Signalleitungsanschlüssen 9₁, 9₂ des ersten HF-Combiners 1, 1ₐ oder des ersten HF-Combiners 1ₐ der ersten HF-Combineranordnung 3, 3ₐ elektrisch verbunden. Die zweiten Signalanschlüsse 50ₐ₂, 50_{b2} der Basisstation 50ₐ, 50_{b} sind dagegen mit den Signalleitungsanschlüssen 9₁, 9₂ des zweiten HF-Combiners 1, 1_{b} oder des zweiten HF-Combiners 1_{b} der ersten HF-Combineranordnung 3, 3ₐ verbunden.

Es sind weiterhin ein erstes und ein zweites Feeder-Kabel 51ₐ, 51_{b} vorgesehen. Das erste Feeder-Kabel 51ₐ ist mit seinem ersten Ende mit dem Common-Anschluss 8 des ersten HF-Combiners 1, 1ₐ oder dem Common-Anschluss 8 des ersten HF-Combiners 1ₐ der ersten HF-Combineranordnung 3, 3ₐ elektrisch verbunden. Das zweite Feeder-Kabel 51_{b} ist mit seinem ersten Ende mit dem Common-Anschluss 8 des zweiten HF-Combiners 1, 1_{b} oder dem Common-Anschluss 8 des zweiten HF-Combiners 1_{b} der ersten HF-Combineranordnung 3, 3ₐ elektrisch verbunden.

Ein zweites Ende des ersten Feeder-Kabels 51ₐ ist mit einem ersten Anschluss 52ₐ eines DualBand-DTMAs 52 verbunden. Ein zweites Ende des zweiten Feeder-Kabels 5 1_{b} ist mit einem zweiten Anschluss 52_{b} des DualBand-DTMAs 52 verbunden.

In Figur 5 werden die ersten und zweiten HF-Combiner 1, 1ₐ, 1_{b} bzw. die ersten und zweiten HF-Combiner 1ₐ, 1_{b} der ersten HF-Combineranordnung 3, 3ₐ im BTS-Betriebszustand betrieben, weil die Speisung mit einem DC-Signal von der jeweiligen Basisstation 50ₐ, 50_{b} über den entsprechenden Signalleitungsanschluss 9₁, 9₂ erfolgt.

Die Basisstationen 50ₐ, 50_{b} können an ihren Anschlüssen 50ₐ₁, 50ₐ₂, 50_{b1}, 50_{b2} entweder kein Signal, ein DC-Signal ein AISG-Signal oder ein AISG- + DC-Signal ausgeben. Es wird dabei lediglich nur ein AISG-Signal pro Basisstation 50a, 50b ausgegeben.

Bevorzugt ist der Anschluss der HF-Combiner 1, 1ₐ, 1_{b} an die jeweilige Basisstation 50ₐ, 50_{b} derart, dass nur an jeweils einem Signalleitungsanschluss 9₁, 9₂ des jeweiligen HF-Combiners 1, 1ₐ, 1_{b} ein AISG-Signal anliegt. Dieser Sachverhalt ist in Figur 5 gezeigt.

Die Steuervorrichtung 30 ermittelt das Vorhandensein eines AISG-Signals und schaltet die entsprechende Umgehungsleitung 20₁, 20₂ von der Signalleitungsanschlusskontaktierung 19₁, 19₂ auf die Common-Anschlusskontaktierung 18 durch. Dadurch steht das ASIG-Signal auch an der elektrischen Funktionseinrichtung 52 zu Verfügung.

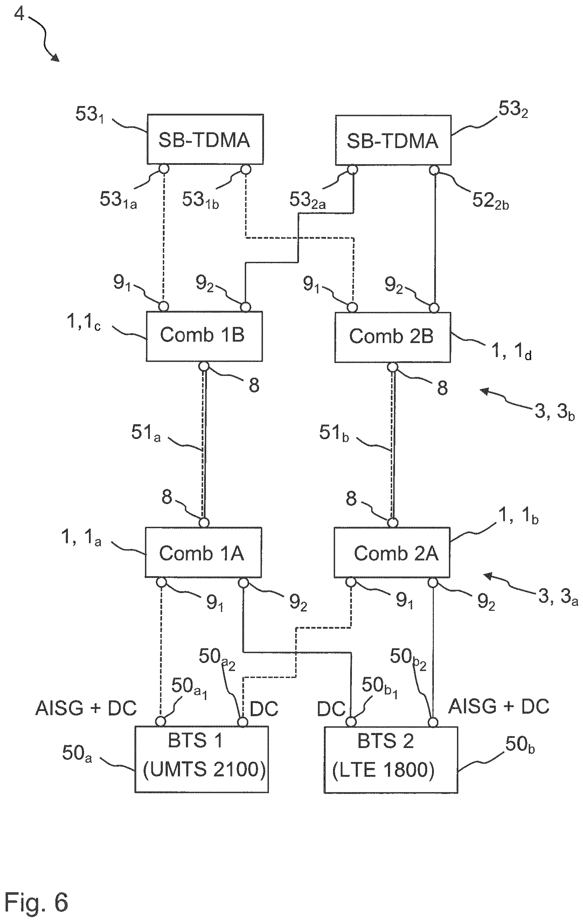

Figur 6 zeigt ein weiteres Ausführungsbeispiel der erfindungsgemäßen Mobilfunk-Site 4. Im Gegensatz zu Figur 5 werden keine DualBand-DTMAs 52 verwendet, sondern n SingleBand-DTMAs 53₁, 53₂. Der Aufbau, inklusive des Anschluss des ersten und des zweiten Feeder-Kabels 51ₐ, 51_{b} an den ersten und zweiten HF-Combiner 1, 1ₐ, 1_{b} bzw. an den ersten und zweiten HF-Combiner 1ₐ, 1_{b} der ersten HF-Combineranordnung 3, 3ₐ entspricht demjenigen Aufbau, wie er in Figur 5 beschrieben wurde.

Figur 6 zeigt dagegen noch den Einsatz eines dritten und eines vierten HF-Combiners 1_{c}, 1_{d} bzw. eine zweite HF-Combineranordnung 3, 3_{b}. Ein Common-Anschluss 8 des dritten HF-Combiners 1_{c} oder ein Common-Anschluss 8 des dritten HF-Combiners 1_{c} der zweiten HF-Combineranordnung 3, 3_{b} ist mit einem zweiten Ende des ersten Feeder-Kabels 51ₐ elektrisch verbunden. Ein Common-Anschluss 8 des vierten HF-Combiners 1, 1_{d} oder ein Common-Anschluss 8 des vierten HF-Combiners 1_{d} der zweiten HF-Combineranordnung 3, 3_{b} ist mit einem zweiten Ende des zweiten Feeder-Kabels 51_{b} elektrisch verbunden. Die dritten und vierten HF-Combiner 1_{c}, 1_{d} sind entsprechend der Figuren 1 bis 3 aufgebaut.

Die n Signalleitungsanschlüsse 9₁, 9₂ des dritten HF-Combiners 1, 1_{c} oder die n Signalleitungsanschlüsse 9₁, 9₂ des dritten HF-Combiners 1_{c} der zweiten HF-Combineranordnung 3, 3_{b} sind mit ersten Anschlüssen 53₁ₐ, 53₂ₐ der SingleBand-DTMAs 53₁, 53₂ elektrisch verbunden. Die Signalleitungsanschlüsse 9₁, 9₂ des vierten HF-Combiners 1, 1_{d} oder die Signalleitungsanschlüsse 9₁, 9₂ des vierten HF-Combiners 1_{d} der zweiten HF-Combineranordnung 3, 3_{b} sind mit zweiten Anschlüssen 53_{1b}, 53_{2b} der SingleBand-DTMAs 53₁, 53₂ elektrisch verbunden.

Die dritten und vierten Combiner 1, 1_{c}, 1_{d} bzw. die dritten und vierten Combiner 1_{c}, 1_{d} der zweiten HF-Combineranordnung 3, 3_{b} werden im ANT-Betriebszustand betrieben, weil die Speisung durch ein DC-Signal über das jeweilige Feeder-Kabel 51ₐ, 5 1_{b} an dem Common-Anschluss 8 erfolgt.

Bevorzugt sind alle vier HF-Combiner 1, 1ₐ, 1_{b}, 1_{c}, 1_{d} identisch aufgebaut. Innerhalb des Betriebs, also nachdem sie mit einer Spannung versorgt werden, wird die jeweilige Konfiguration, also der BTS-Betriebszustand oder der ANT-Betriebszustand geladen. Insgesamt kann durch Einsatz des erfindungsgemäßen universellen HF-Combiners 1 eine sehr flexible Lösung für Mobilfunk-Sites 4 geschaffen werden.

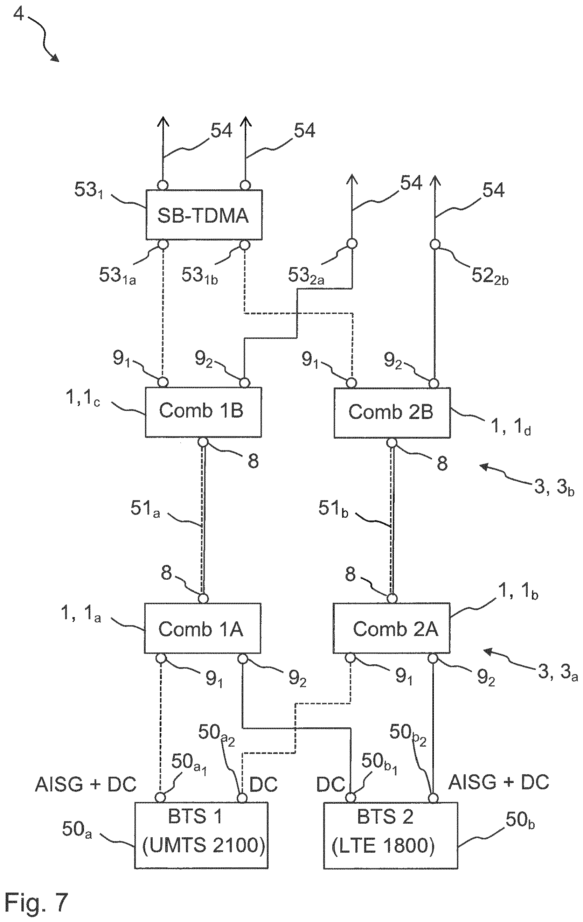

Figur 7 zeigt ein weiteres Ausführungsbeispiel der erfindungsgemäßen Mobilfunk-Site 4. Es entspricht dabei im Wesentlichen demjenigen aus Figur 6. Im Unterschied dazu gibt es nur einen SingleBand-DTMA 53₁. Dieser ist mit seinen Anschlüssen 53_{1a,} 53_{1b} mit den ersten Signalleitungsanschlüssen 9₁ des dritten und vierten Combiners 1, 1_{c}, 1_{d} verbunden. An den zweiten Signalleitungsanschlüssen 9₂ des dritten und vierten Combiners 1, 1_{c}, 1_{d} sind dagegen direkt Antennenelemente 54 angeordnet. In diesem Fall, darf kein DC-Signal auf die zweiten Signalleitungsanschlüsse 9₂ des dritten und vierten Combiners 1, 1_{c}, 1_{d} geschaltet werden.

Die Erfindung ist nicht auf die beschriebenen Ausführungsbeispiele beschränkt, da der Schutzumfang nur durch die angehängten Ansprüche definiert wird.

## Patentansprüche

1. HF-Combiner (1) zum Einsatz in Mobilfunk-Sites (4) umfassend die folgenden Merkmale:
- zumindest ein Gehäuse (5) mit einem Common-Anschluss (8) und n Signalleitungsanschlüssen (9₁, 9₂, ..., 9ₙ) mit n ≥ 2, n ≥ 3 oder n ≥ 4, wobei der Common-Anschluss (8) und die n Signalleitungsanschlüsse (9₁, 92, ..., 9n) an dem Gehäuse (5) angebracht sind;
- die n Signalleitungsanschlüsse (9₁, 9₂, ..., 9ₙ) sind innerhalb des Gehäuses (5) mit dem Common-Anschluss (8) über jeweils einen von n Filterpfaden (12₁, 12₂, ..., 12ₙ) verbunden und/oder gekoppelt;
- eine Leiterplattenanordnung (11);
- die Leiterplattenanordnung (11) weist eine Common-Anschlusskontaktierung (18) auf, die mit dem Common-Anschluss (8) galvanisch verbunden ist;
- die Leiterplattenanordnung (11) weist n Signalleitungsanschlusskontaktierungen (19₁, 19₂, ..., 19ₙ) auf, wobei jede der n Signalleitungsanschlusskontaktierungen (19₁, 19₂, ..., 19ₙ) mit einem der n Signalleitungsanschlüsse (9₁, 9₂, ..., 9ₙ) galvanisch verbunden ist;
- zwischen dem Common-Anschluss (8) und der Common-Anschlusskontaktierung (18) ist zumindest ein Tiefpassfilter (17) angeordnet und/oder zwischen zumindest einem oder allen der n Signalleitungsanschlüsse (9₁, 9₂, ..., 9ₙ) und der entsprechenden Signalleitungsanschlusskontaktierung (19₁, 19₂, ..., 19ₙ) ist jeweils zumindest ein Tiefpassfilter (17) angeordnet;
- die Leiterplattenanordnung (11) umfasst n Umgehungsleitungen (20₁, 20₂, ..., 20n);
- jede der n Signalleitungsanschlusskontaktierungen (19₁, 19₂, ..., 19ₙ) ist über jeweils eine der n Umgehungsleitungen (20₁, 20₂, ..., 20ₙ) mit der Common-Anschlusskontaktierung (18) elektrisch verbunden oder verbindbar;
- eine Elektronikeinrichtung (2), die eine Steuervorrichtung (30), eine Detektoreinrichtung (16) und zumindest n Signalleitungs-Schalteinrichtungen (32₁, 32₂, ..., 32ₙ) aufweist;
- die n Signalleitungs-Schalteinrichtungen (32₁, 32₂, ..., 32ₙ) umfassen jeweils zumindest eine erste Schalteinheit (32₁ₐ, 32₂ₐ, ..., 32ₙₐ), wobei in jeder der n Umgehungsleitungen (20₁, 20₂, ..., 20ₙ) die jeweilige zumindest eine erste Schalteinheit (32₁ₐ, 32₂ₐ, ..., 32ₙₐ) angeordnet ist;
- die Detektoreinrichtung (16) ist:
a) an den n Signalleitungsanschlusskontaktierungen (19₁, 19₂, ..., 19ₙ) angeschlossen oder angekoppelt; oder
b) zwischen den n Signalleitungsanschlüssen (9₁, 9₂, ..., 9ₙ) und den n Signalleitungs-Schalteinrichtungen (32₁, 32₂, ..., 32ₙ) angeschlossen oder angekoppelt;
- **gekennzeichnet dadurch, dass** die Detektoreinrichtung (16) in einem BTS-Betriebszustand dazu ausgebildet ist, zu detektieren, ob an einer der n Signalleitungsanschlusskontaktierungen (19₁, 19₂, ..., 19ₙ) ein AISG-Signal anliegt;
- die Steuervorrichtung (30) oder die Detektoreinrichtung (16) bei der Detektion eines AISG-Signals an einer der n Signalleitungsanschlusskontaktierungen (19₁, 19₂, ..., 19ₙ) dazu ausgebildet ist, die erste Schalteinheit (32₁ₐ, 32₂ₐ, ..., 32ₙₐ) in der jeweiligen der n Umgehungsleitungen (20₁, 20₂, ..., 20ₙ) derart anzusteuern, dass diese diejenige der n Signalleitungsanschlusskontaktierungen (19₁, 19₂, ..., 19ₙ), an welcher das AISG-Signal detektiert wurde, mit der Common-Anschlusskontaktierung (18) elektrisch verbindet.

2. HF-Combiner (1) nach Anspruch 1, umfassend das folgende Merkmal:
- die elektrische Verbindung, über die das AISG-Signal von der entsprechenden Signalleitungsanschlusskontaktierung (19₁, 19₂, ..., 19ₙ) an die Common-Anschlusskontaktierung (18) übertragen wird, ist niederohming und/oder frei von Signalumsetzern.

3. HF-Combiner (1) nach Anspruch 1 oder 2, umfassend die folgenden Merkmale:
- die Elektronikeinrichtung (2) weist einen Common-Signalsplitter (35) und n Anschluss-Signalsplitter (36₁, 36₂, ..., 36ₙ) auf;
- der Common-Signalsplitter (35) und die n Anschluss-Signalsplitter (18) umfassen jeweils einen ersten, einen zweiten und einen dritten Anschluss und sind dazu ausgebildet:
a) ein Mischsignal aus einem DC-Signal und einem AISG-Signal, welches an dem ersten Anschluss anliegt, aufzuteilen und das DC-Signal an dem zweiten Anschluss und das AISG-Signal an dem dritten Anschluss auszugeben;
b) ein DC-Signal, das an dem zweiten Anschluss anliegt und ein AISG-Signal, das an dem dritten Anschluss anliegt zusammenzufassen und als Mischsignal an dem ersten Anschluss auszugeben;
- der Common-Signalsplitter (35) ist mit seinem ersten Anschluss mit der Common-Anschlusskontaktierung (18) elektrisch verbunden;
- jeder der n Anschluss-Signalsplitter (36₁, 36₂, ..., 36ₙ) ist mit seinem ersten Anschluss mit einer der n Signalleitungsanschlusskontaktierungen (19₁, 19₂, ..., 19ₙ) elektrisch verbunden, wodurch jede der n Umgehungsleitungen (20₁, 20₂, ..., 20ₙ) in ein AISG-Leitungssegment (20₁ₐ, 20₂ₐ, ..., 20ₙₐ) und in ein DC-Leitungssegment (20_{1b}, 20_{2b}, ..., 20_{nb}) aufgeteilt sind, wobei das DC-Leitungssegment (20_{1b}, 20_{2b}, ..., 20_{nb}) am zweiten Anschluss des jeweiligen Anschluss-Signalsplitters (36₁, 36₂, ..., 36ₙ) und das AISG-Leitungssegment (20₁ₐ, 20₂ₐ, ..., 20ₙₐ) am dritten Anschluss des jeweiligen Anschluss-Signalsplitters (36₁, 36₂, ..., 36ₙ) beginnt;
- die zweiten Anschlüsse der n Anschluss-Signalsplitter (36₁, 36₂, ..., 36ₙ) sind elektrisch miteinander und mit dem zweiten Anschluss des Common-Signalsplitters (35) verbunden;
- die dritten Anschlüsse der n Anschluss-Signalsplitter (36₁, 36₂, ..., 36ₙ) sind elektrisch miteinander und mit dem dritten Anschluss des Common-Signalsplitters (35) verbunden;
- in jedem AISG-Leitungssegment (20₁ₐ, 20₂ₐ, ..., 20ₙₐ) ist jeweils die erste Schalteinheit (32₁ₐ, 32₂ₐ, ..., 32ₙₐ) einer der n Signalleitungs-Schalteinrichtungen (32₁, 32₂, ..., 32ₙ) angeordnet.

4. HF-Combiner (1) nach einem der vorherigen Ansprüche, umfassend die folgenden Merkmale:
- die erste Schalteinheit (32₁ₐ, 32₂ₐ, ..., 32ₙₐ) der n Signalleitungs-Schalteinrichtungen (32₁, 32₂, ..., 32ₙ) ist ein Relais; und/oder
- die n Signalleitungs-Schalteinrichtungen (32₁, 32₂, ..., 32ₙ) umfassen jeweils zumindest eine zweite Schalteinheit (32_{1b}, 32_{2b}, ..., 32_{nb}), wobei
- in jedem DC-Leitungssegment (20_{1b}, 20_{2b}, ..., 20_{nb}) jeweils eine zweite Schalteinheit (32_{1b}, 32_{2b}, ..., 32_{nb}) einer der n Signalleitungs-Schalteinrichtungen (32₁, 32₂, ..., 32ₙ) angeordnet ist,
wobei die zweite Schalteinheit (32_{1b}, 32_{2b}, ..., 32_{nb}) der n Signalleitungs-Schalteinrichtungen (32₁, 32₂, ..., 32ₙ) ein Relais ist.

5. HF-Combiner (1) nach einem der vorherigen Ansprüche, umfassend die folgenden Merkmale:
- die Detektoreinrichtung (16) ist außerdem:
a) an der Common-Anschlusskontaktierung (18) angeschlossen oder angekoppelt; oder
b) zwischen dem Common-Anschluss (8) und den n Signalleitungs-Schalteinrichtungen (32₁, 32₂, ..., 32ₙ) angeschlossen oder angekoppelt;
- die Detektoreinrichtung (16) ist dazu ausgebildet zu detektieren, ob an einer der n Signalleitungsanschlusskontaktierungen (19₁, 19₂, ..., 19ₙ) ein DC-Signal anliegt;
- die Detektoreinrichtung (16) ist dazu ausgebildet zu detektieren, ob an der Common-Anschlusskontaktierung (18) ein DC-Signal anliegt;
- die Steuervorrichtung (30) ist dazu ausgebildet, beim Starten einen Startbetriebszustand einzunehmen und von diesem in:
a) den BTS-Betriebszustand überzugehen, wenn die Detektoreinrichtung (16) ein DC-Signal an einer der n Signalleitungsanschlusskontaktierungen (19₁, 19₂, ..., 19ₙ) detektiert; oder
b) einen ANT-Betriebszustand überzugehen, wenn die Detektoreinrichtung (16) ein DC-Signal an der Common-Anschlusskontaktierung (18) detektiert.

6. HF-Combiner (1) nach Anspruch 5, umfassend die folgenden Merkmale:
- die Steuervorrichtung (30) ist im BTS-Betriebszustand dazu ausgebildet, diejenige der n Signalleitungsanschlusskontaktierungen (19₁, 19₂, ..., 19ₙ), an welcher ein DC-Signal als erstes detektiert wurde, durch Ansteuern der entsprechenden Signalleitungs-Schalteinrichtung (32₁, 32₂, ..., 32ₙ) mit der Common-Anschlusskontaktierung (18) elektrisch zu verbinden, wobei die Steuervorrichtung (30) im BTS-Betriebszustand weiter dazu ausgebildet ist, diejenigen anderen Signalleitungsanschlusskontaktierungen (19₁, 19₂, ..., 19ₙ), an denen ein DC-Signal erst später oder überhaupt nicht detektiert wurde, durch Ansteuern der entsprechenden Signalleitungs-Schalteinrichtungen (32₁, 32₂, ..., 32ₙ) von der Common-Anschlusskontaktierung (18) elektrisch zu trennen.

7. HF-Combiner (1) nach Anspruch 6, umfassend die folgenden Merkmale:
- die Steuervorrichtung (30) ist im BTS-Betriebszustand dazu ausgebildet, dass für den Fall, dass die Detektoreinrichtung (16):
a) ein AISG-Signal an einer der n Signalleitungsanschlusskontaktierungen (19₁, 19₂, ..., 19ₙ) detektiert, die entsprechende Signalleitungs-Schalteinrichtung (32₁, 32₂, ..., 32ₙ) derart anzusteuern, dass diese die jeweilige Signalleitungsanschlusskontaktierung (19₁, 19₂, ..., 19ₙ) mit der Common-Anschlusskontaktierung (18) elektrisch verbindet, sodass das AISG-Signal an der Common-Anschlusskontaktierung (18) anliegt; oder
b) ein AISG-Signal und ein DC-Signal an einer der n Signalleitungsanschlusskontaktierungen (19₁, 19₂, ..., 19ₙ) detektiert, die entsprechende Signalleitungs-Schalteinrichtung (32₁, 32₂, ..., 32ₙ) derart anzusteuern, dass diese die jeweilige Signalleitungsanschlusskontaktierung (19₁, 19₂, ..., 19ₙ) mit der Common-Anschlusskontaktierung (18) elektrisch verbindet, sodass das AISG-Signal und das DC-Signal an der Common-Anschlusskontaktierung (18) anliegen, wobei die Steuervorrichtung (30) weiter dazu ausgebildet ist, die anderen aktivierten Signalleitungs-Schalteinrichtungen (32₁, 32₂, ..., 32ₙ) derart anzusteuern, dass diese eine elektrische Verbindung zwischen ihren jeweiligen Signalleitungsanschlusskontaktierungen (19₁, 19₂, ..., 19ₙ) und der Common-Anschlusskontaktierung (18) trennen.

8. HF-Combiner (1) nach Anspruch 7, umfassend das folgende Merkmal:
- die Steuervorrichtung (30) ist im BTS-Betriebszustand dazu ausgebildet, dass für den Fall, dass die Detektoreinrichtung (16) ein AISG-Signal und ein DC-Signal an einer der n Signalleitungsanschlusskontaktierungen (19₁, 19₂, ..., 19ₙ) detektiert, wobei eine andere Signalleitungsanschlusskontaktierung (19₁, 19₂, ..., 19ₙ) zur Übertragung eines DC-Signals bereits mit der Common-Anschlusskontaktierung (18) elektrisch verbunden ist, die entsprechende Signalleitungs-Schalteinrichtung (32₁, 32₂, ..., 32ₙ) derjenigen Signalleitungsanschlusskontaktierung (19₁, 19₂, ..., 19ₙ), an welcher das AISG-Signal und das DC-Signal detektiert wurde, derart anzusteuern, dass diese die jeweilige Signalleitungsanschlusskontaktierung (19₁, 19₂, ..., 19ₙ) mit der Common-Anschlusskontaktierung (18) elektrisch verbindet, sodass an dieser das AISG-Signal und das DC-Signal anliegt und die bisherige Verbindung der anderen Signalleitungsanschlusskontaktierung (19₁, 19₂, ..., 19ₙ) mit der Common-Anschlusskontaktierung (18) elektrisch auftrennt, wobei dieser Wechsel unterbrechungsfrei erfolgt, so dass an der Common-Anschlusskontaktierung (18) immer ein DC-Signal anliegt.

9. HF-Combiner (1) nach einem der Ansprüche 6 bis 8, umfassend das folgende Merkmal:
- die Detektoreinrichtung (16) ist dazu ausgebildet zu detektieren, ob an der Common-Anschlusskontaktierung (18) ein Kurzschluss vorliegt, wobei die Steuervorrichtung (30) weiter dazu ausgebildet ist, die entsprechende Signalleitungsanschlusskontaktierung (19₁, 19₂, ..., 19ₙ) nur dann mit der Common-Anschlusskontaktierung (18) zu verbinden, wenn durch die Detektoreinrichtung (16) kein Kurzschluss detektiert wurde.

10. HF-Combiner (1) nach einem der Ansprüche 5 bis 9, umfassend das folgende Merkmal:
- die Steuervorrichtung (30) ist im Startbetriebszustand dazu ausgebildet, die n Signalleitungs-Schalteinrichtungen (32₁, 32₂, ..., 32ₙ) derart anzusteuern, dass diese die n Umgehungsleitungen (20₁, 20₂, ..., 20ₙ) unterbrechen, wodurch die n Signalleitungsanschlusskontaktierungen (19₁, 19₂, ..., 19ₙ) elektrisch von der Common-Anschlusskontaktierung (18) getrennt sind.

11. HF-Combiner (1) nach Anspruch 5, umfassend das folgende Merkmal:
- die Detektoreinrichtung (16) ist dazu ausgebildet, einen Kurzschluss an den n Signalleitungsanschlusskontaktierungen (19₁, 19₂, ..., 19ₙ) zu detektieren, wobei die Steuervorrichtung (30) im ANT-Betriebszustand dazu ausgebildet ist, die Common-Anschlusskontaktierung (18) lediglich mit denjenigen der n Signalleitungsanschlusskontaktierungen (19₁, 19₂, ..., 19ₙ) elektrisch durch Ansteuern der entsprechenden Signalleitungs-Schalteinrichtungen (32₁, 32₂, ..., 32ₙ) zu verbinden, an denen kein Kurzschluss detektiert wurde.

12. HF-Combiner (1) nach einem der Ansprüche 5 bis 11 umfassend das folgende Merkmal:
- die Steuervorrichtung (30) ist im BTS-Betriebszustand oder im ANT-Betriebszustand dazu ausgebildet, die n Signalleitungs-Schalteinrichtungen (32₁, 32₂, ..., 32ₙ) derart anzusteuern, dass diese die n Signalleitungsanschlusskontaktierungen (19₁, 19₂, ..., 19ₙ) elektrisch von der Common-Anschlusskontaktierung (18) trennen, wenn ein Pegel der DC-Signale an den n Signalleitungsanschlusskontaktierungen (19₁, 19₂, ..., 19ₙ) und der Common-Anschlusskontaktierung (18) unter einen einstellbaren Schwellwert abfällt.

13. HF-Combiner (1) nach einem der vorherigen Ansprüche, umfassend das folgende Merkmal:
- die Steuervorrichtung (30) ist im BTS-Betriebszustand dazu ausgebildet, bei der Detektion eines AISG-Signals an einer der n Signalleitungsanschlusskontaktierungen (19₁, 19₂, ..., 19ₙ) durch die Detektoreinrichtung (16), die erste Schalteinheit (32₁ₐ, 32₂ₐ, ..., 32ₙₐ) der entsprechenden Signalleitungs-Schalteinrichtung (32₁, 32₂, ..., 32ₙ) in einem Zeitraum anzusteuern, dass der erste On/Off-Keying-Impuls des als On/Off-Keying-Signals ausgebildeten AISG-Signals noch zu mehr als 70%, 80%, 90% an die Common-Anschlusskontaktierung (18) übertragbar ist.

14. HF-Combineranordnung (3) mit einem ersten und einem zweiten HF-Combiner (1; 1a, 1b), die gemäß einem der vorherigen Ansprüche aufgebaut sind, wobei der erste und der zweite HF-Combiner (1; 1a, 1b) außerdem noch die folgenden Merkmale umfassen:
- das Gehäuse (5) des ersten und der zweiten HF-Combiners (1; 1a, 1b) ist in Cavity-Bauweise aufgebaut und umfasst einen Gehäuseboden (6), die vom Gehäuseboden (6) beabstandete Leitplattenanordnung (11) und eine zwischen dem Gehäuseboden (6) und der Leiterplattenanordnung (11) umlaufende Gehäusewand (7), wodurch ein Aufnahmeraum (15) begrenzt ist;
- in jedem Filterpfad (12₁, 12₂, ..., 12ₙ) ist zumindest ein Resonator-Innenleiter (13) angeordnet, der mit dem Gehäuseboden (6) des Gehäuses (5) galvanisch verbunden ist und sich in axialer Richtung vom Gehäuseboden (6) in Richtung der Leiterplattenanordnung (11) erstreckt und in einem Abstand von der Leiterplattenanordnung (11) endet und/oder von dieser galvanisch getrennt ist;
- die einzelnen Filterpfade (12₁, 12₂, ..., 12ₙ), in denen jeweils zumindest ein Resonator-Innenleiter (13) angeordnet ist, sind voneinander zumindest teilweise durch eine Wand (14) getrennt, die galvanisch mit dem Gehäuseboden (6) verbunden ist und sich in Richtung der Leiterplattenanordnung (11) erstreckt;
und wobei die HF-Combineranordnung (3) das folgende Merkmal umfasst:
- der erste und der zweite HF-Combiner (1; 1a, 1b) sind aufeinander gesetzt, wobei die Leitplattenanordnung (11) den Aufnahmeraum (15) des ersten HF-Combiners (1; 1a) von dem Aufnahmeraum (15) des zweiten HF-Combiners (1; 1b) elektrisch und/oder elektromagnetisch trennt und umgekehrt.

15. Mobilfunk-Site (4) mit zumindest zwei HF-Combinern (1; 1ₐ, 1_{b}) nach einem der Ansprüche 1 bis 13 und/oder zumindest einer erstem HF-Combineranordnung (3; 3ₐ) nach Anspruch 14, umfassend die folgenden Merkmale:
- n Basisstationen (50ₐ, 50_{b}, ..., 50ₙ), wobei die n Basisstationen (50ₐ, 50_{b}, ..., 50ₙ) in unterschiedlichen Mobilfunkbändern betreibbar sind;
- jede der n Basisstationen (50ₐ, 50_{b}, ..., 50ₙ) hat zwei Signalanschlüsse (50ₐ₁, 50ₐ₂, 50_{b1}, 50_{b2}, ..., 50ₙ₁, 50ₙ₂), wobei die n Basisstationen (50ₐ, 50_{b}, ..., 50ₙ) dazu ausgebildet sind, an einem ersten Signalanschluss (50ₐ₁, 50_{b1}, ..., 50ₙ₁) bevorzugt ein MAIN-Signal auszusenden und/oder zu empfangen und wobei die n Basisstationen (50ₐ, 50_{b}, ..., 50ₙ) dazu ausgebildet sind, an einem zweiten Signalanschluss (50ₐ₂, 50_{b2}, ..., 50ₙ₂) bevorzugt ein DIV-Signal auszusenden und/oder zu empfangen;
- die ersten Signalanschlüsse (50ₐ₁, 50_{b1}, ..., 50ₙ₁) der n Basisstationen (50ₐ, 50_{b}, ..., 50ₙ) sind mit den n Signalleitungsanschlüssen (9₁, 9₂, ..., 9ₙ) des ersten HF-Combiners (1; 1ₐ) oder des ersten HF-Combiners (1; 1ₐ) der ersten HF-Combineranordnung (3; 3ₐ) elektrisch verbunden;
- die zweiten Signalanschlüsse (50ₐ₂, 50_{b2}, ..., 50ₙ₂) der n Basisstationen (50ₐ, 50_{b}, ..., 50ₙ) sind mit den n Signalleitungsanschlüssen (9₁, 9₂, ..., 9ₙ) des zweiten HF-Combiners (1; 1_{b}) oder des zweiten HF-Combiners (1; 1_{b}) der ersten HF-Combineranordnung (3; 3ₐ) elektrisch verbunden;
- ein erstes und ein zweites Feeder-Kabel (51ₐ, 51_{b});
- das erste Feeder-Kabel (51ₐ) ist mit seinem ersten Ende mit dem Common-Anschluss (8) des ersten HF-Combiners (1; 1ₐ) oder dem Common-Anschluss (8) des ersten HF-Combiners (1; 1ₐ) der ersten HF-Combineranordnung (3; 3ₐ) elektrisch verbunden;
- das zweite Feeder-Kabel (51_{b}) ist mit seinem ersten Ende mit dem Common-Anschluss (8) des zweiten HF-Combiners (1; 1_{b}) oder dem Common-Anschluss (8) des zweiten HF-Combiners (1; 1_{b}) der ersten HF-Combineranordnung (3; 3ₐ) elektrisch verbunden.

## Claims

1. An HF combiner (1) for use in mobile radio sites (4), having the following features:
- at least one housing (5) having a common terminal (8) and n signal line terminals (9₁, 9₂, ..., 9ₙ), where n ≥ 2, n ≥ 3, or n ≥ 4, the common terminal (8) and the n signal line terminals (91, 92, ..., 9n) being mounted on the housing (5);
- the n signal line terminals (9₁, 9₂, ..., 9ₙ) are connected and/or coupled to the common terminal (8) within the housing (5) via one of n filter paths (12₁, 12₂, ..., 12ₙ) in each case;
- a circuit board arrangement (11);
- the circuit board arrangement (11) has a common terminal contact (18) that is galvanically connected to the common terminal (8);
- the circuit board arrangement (11) has n signal line terminal contacts (19₁, 19₂, ..., 19ₙ), each of the n signal line terminal contacts (19₁, 19₂, ..., 19ₙ) being galvanically connected to one of the n signal line terminals (9₁, 9₂, ..., 9ₙ);
- at least one low-pass filter (17) is situated between the common terminal (8) and the common terminal contact (18,) and/or at least one low-pass filter (17) is situated in each case between at least one or all of the n signal line terminals (9₁, 9₂, ..., 9ₙ) and the corresponding signal line terminal contact (19₁, 19₂, ..., 19ₙ);
- the circuit board arrangement (11) includes n bypass lines (20₁, 20₂, ..., 20ₙ);
- each of the n signal line terminal contacts (19₁, 19₂, ..., 19ₙ) is electrically connected or connectable to the common terminal contact (18) via one of the n bypass lines (20₁, 20₂, ..., 20ₙ) in each case;
- an electronics unit (2) has a control device (30), a detector device (16), and at least n signal line switching devices (32₁, 32₂, ..., 32ₙ);
- the n signal line switching devices (32₁, 32₂, ..., 32ₙ) each include at least one first switching unit (32₁ₐ, 322a, ..., 32ₙₐ), the respective at least one first switching unit (32₁ₐ, 322a, ..., 32ₙₐ) being situated in each of the n bypass lines (20₁, 20₂, ..., 20ₙ);
- the detector device (16) is:
a) connected or coupled to the n signal line terminal contacts (19₁, 19₂, ..., 19ₙ); or
b) connected or coupled between the n signal line terminals (9₁, 9₂, ..., 9ₙ) and the n signal line switching devices (32₁, 32₂, ..., 32ₙ);
- **characterized in that** the detector device (16), in a BTS operating state, is designed to detect whether an AISG signal is present at one of the n signal line terminal contacts (19₁, 19₂, ..., 19n);
- the control device (30) or the detector device (16), when an AISG signal is detected at one of the n signal line terminal contacts (19₁, 19₂, ..., 19ₙ), is designed to control the first switching unit (32₁ₐ, 32₂ₐ, ..., 32ₙₐ) in the respective one of the n bypass lines (20₁, 20₂, ..., 20ₙ) in such a way that the first switching unit electrically connects the particular one of the n signal line terminal contacts (19₁, 19₂, ..., 19ₙ), at which the AISG signal has been detected, to the common terminal contact (18).

2. The HF combiner (1) according to claim 1, comprising the following feature:
- the electrical connection, via which the AISG signal from the particular signal line terminal contact (19₁, 19₂, ..., 19ₙ) is transmitted to the common terminal contact (18), is low resistance and/or free from signal converters.

3. The HF combiner (1) according to either claim 1 or claim 2, comprises the following features:
- the electronics unit (2) has a common signal splitter (35) and n terminal signal splitters (36₁, 36₂, ..., 36ₙ);
- the common signal splitter (35) and the n terminal signal splitters (18) each include a first, a second, and a third terminal and are designed to:
a) divide a mixed signal that is composed of a DC signal and an AISG signal and that is present at the first terminal, and to output the DC signal at the second terminal and output the AISG signal at the third terminal;
b) combine a DC signal that is present at the second terminal, and an AISG signal that is present at the third terminal, and output them as a mixed signal at the first terminal;
- the common signal splitter (35) at its first terminal is electrically connected to the common terminal contact (18);
- each of the n terminal signal splitters (36₁, 36₂, ..., 36ₙ) with its first terminal is electrically connected to one of the n signal line terminal contacts (19₁, 19₂, ..., 19ₙ), as the result of which each of the n bypass lines (20₁, 20₂, ..., 20ₙ) is divided into an AISG line segment (20₁ₐ, 20₂ₐ, ..., 20ₙₐ) and a DC line segment (20_{1b}, 20₂b, ..., 20_{nb}), the DC line segment (20_{1b}, 20_{2b}, ..., 20_{nb}) beginning at the second terminal of the respective terminal signal splitter (36₁, 36₂, ..., 36n), and the AISG line segment (20₁ₐ, 20₂ₐ, ..., 20ₙₐ) beginning at the third terminal of the respective terminal signal splitter (36₁, 36₂, ..., 36ₙ);
- the second terminals of the n terminal signal splitters (36₁, 36₂, ..., 36ₙ) are electrically connected to one another and to the second terminal of the common signal splitter (35);
- the third terminals of the n terminal signal splitters (36₁, 36₂, ..., 36ₙ) are electrically connected to one another and to the third terminal of the common signal splitter (35);
- in each case the first switching unit (32₁ₐ, 32₂ₐ, ..., 32ₙₐ) of one of the n signal line switching devices (32₁, 32₂, ..., 32ₙ) is situated in each AISG line segment (20₁ₐ, 20₂ₐ, ..., 20ₙₐ).

4. The HF combiner (1) according to any of the preceding claims, comprises the following features:
- the first first switching unit (32₁ₐ, 32₂ₐ, ..., 32ₙₐ) of the n signal line switching devices (32₁, 32₂, ..., 32ₙ) is a relais; and/or
- the n signal line switching devices (32₁, 32₂, ..., 32ₙ) each include at least one second switching unit (32_{1b}, 32_{2b}, ..., 32_{nb}); wherein
- in each case a second switching unit (32_{1b}, 32_{2b}, ..., 32_{nb}) of one of the n signal line switching devices (32₁, 32₂, ..., 32ₙ) is situated in each DC line segment (20_{1b}, 20_{2b}, ..., 20_{nb}), wherein the second switching unit (32_{1b}, 32_{2b}, ..., 32_{nb}) of the n signal line switching devices (32₁, 32₂, ..., 32ₙ) is a relay.

5. The HF combiner (1) according to any of the preceding claims, comprises the following features:
- the detector device (16) is also:
a) connected or coupled to the common terminal contact (18); or
b) connected or coupled between the common terminal (8) and the n signal line switching devices (32₁, 32₂, ..., 32ₙ);
- the detector device (16) is designed to detect whether a DC signal is present at one of the n signal line terminal contacts (19₁, 19₂, ..., 19ₙ);
- the detector device (16) is designed to detect whether a DC signal is present at the common terminal contact (18);
- the control device (30) is designed to assume a starting operating state upon starting, and from this state:
a) to change over to the BTS operating state when the detector device (16) detects a DC signal at one of the n signal line terminal contacts (19₁, 19₂, ..., 19ₙ); or
b) to change over to an ANT operating state when the detector device (16) detects a DC signal at the common terminal contact (18).

6. The HF combiner (1) according to claim 5, comprises the following features:
- the control device (30) in the BTS operating state is designed to electrically connect the particular one of the n signal line terminal contacts (19₁, 19₂, ..., 19ₙ) at which a DC signal has first been detected, to the common terminal contact (18) by controlling the corresponding signal line switching device (32₁, 32₂, ..., 32ₙ), the control device (30) in the BTS operating state being further designed to electrically disconnect the particular other signal line terminal contacts (19₁, 19₂, ..., 19ₙ) at which a DC signal has been detected only later or not at all, from the common terminal contact (18) by controlling the corresponding signal line switching devices (32₁, 32₂, ..., 32ₙ).

7. The HF combiner (1) according to 6, comprises the following features:
- the control device (30) in the BTS operating state, for the case that the detector device (16):
a) detects an AISG signal at one of the n signal line terminal contacts (19₁, 19₂, ..., 19ₙ), is designed to control the corresponding signal line switching device (32₁, 32₂, ..., 32ₙ) in such a way that the latter electrically connects the respective signal line terminal contact (19₁, 19₂, ..., 19ₙ) to the common terminal contact (18), so that the AISG signal is present at the common terminal contact (18); or
b) detects an AISG signal and a DC signal at one of the n signal line terminal contacts (19₁, 19₂, ..., 19ₙ), is designed to control the corresponding signal line switching device (32₁, 32₂, ..., 32ₙ) in such a way that the latter electrically connects the respective signal line terminal contact (19₁, 19₂, ..., 19ₙ) to the common terminal contact (18), so that the AISG signal and the DC signal are present at the common terminal contact (18), the control device (30) being further designed to control the other activated signal line switching devices (32₁, 32₂, ..., 32ₙ) in such a way that they disconnect an electrical connection between their respective signal line terminal contacts (19₁, 19₂, ..., 19ₙ) and the common terminal contact (18).

8. The HF combiner (1) according to claim 7, comprises the following feature:
- for the case that the detector device (16) detects an AISG signal and a DC signal at one of the n signal line terminal contacts (19₁, 19₂, ..., 19ₙ), wherein another signal line terminal contact (19₁, 19₂, ..., 19ₙ) for transmitting a DC signal is already electrically connected to the common terminal contact (18), the control device (30) in the BTS operating state is designed to control the corresponding signal line switching device (32₁, 32₂, ..., 32ₙ) of the particular signal line terminal contact (19₁, 19₂, ..., 19ₙ) at which the AISG signal and the DC signal have been detected, in such a way that the signal line switching device electrically connects the respective signal line terminal contact (19₁, 19₂, ..., 19ₙ) to the common terminal contact (18), so that the AISG signal and the DC signal are present at the common terminal contact, and the previous connection of the other signal line terminal contact (19₁, 19₂, ..., 19ₙ) to the common terminal contact (18) is electrically disconnected, this changeover taking place without interruption so that a DC signal is always present at the common terminal contact (18).

9. The HF combiner (1) according to any of claims 6 to 8, comprises the following feature:
- the detector device (16) is designed to detect whether a short circuit is present at the common terminal contact (18), the control device (30) being further designed to connect the corresponding signal line terminal contact (19₁, 19₂, ..., 19ₙ) to the common terminal contact (18) only when no short circuit has been detected by the detector device (16).

10. The HF combiner (1) according to any of claims 5 to 9, comprises the following feature:
- the control device (30) in the starting operating state is designed to control the n signal line switching devices (32₁, 32₂, ..., 32ₙ) in such a way that they disconnect the n bypass lines (20₁, 20₂, ..., 20ₙ), as the result of which the n signal line terminal contacts (19₁, 19₂, ..., 19ₙ) are electrically disconnected from the common terminal contact (18).

11. The HF combiner (1) according to claim 5, cromprises the following feature:
- the detector device (16) is designed to detect a short circuit at the n signal line terminal contacts (19₁, 19₂, ..., 19ₙ), the control device (30) in the ANT operating state being designed to electrically connect the common terminal contact (18) only to the particular one of the n signal line terminal contacts (19₁, 19₂, ..., 19ₙ) at which no short circuit has been detected, by controlling the corresponding signal line switching devices (32₁, 32₂, ..., 32ₙ).

12. The HF combiner (1) according to any of claims 5 to 11, comprises the following feature:
- the control device (30) in the BTS operating state or in the ANT operating state is designed to control the n signal line switching devices (32₁, 32₂,..., 32ₙ) in such a way that they electrically disconnect the n signal line terminal contacts (19₁, 19₂, ..., 19ₙ) from the common terminal contact (18) when a level of the DC signals at the n signal line terminal contacts (19₁, 19₂, ..., 19ₙ) and the common terminal contact (18) drops below a settable threshold value.

13. The HF combiner (1) according to any of the preceding claims, comprise the following feature:
- the control device (30) in the BTS operating state, when an AISG signal is detected at one of the n signal line terminal contacts (19₁, 19₂, ..., 19ₙ) by the detector device (16), is designed to control the first switching unit (32₁ₐ, 32₂ₐ, ..., 32ₙₐ) of the corresponding signal line switching device (32₁, 32₂, ..., 32ₙ) in a time period that the first on/off keying pulse of the AISG signal, designed as an on/off keying signal, is transmittable by more than 70%, 80%, 90% to the common terminal contact (18).

14. The HF combiner arrangement (3), having a first and a second HF combiner (1; 1_{a,} 1_{b}) which are designed according to any of the preceding claims, wherein the first and the second HF combiner in addition also include the following features:
- the housing (5) of the first and the second HF combiner (1; 1_{a,} 1_{b}) has a cavity design, and includes a housing base (6), the circuit board arrangement (11) spaced apart from the housing base (6), and a circumferential housing wall (7) between the housing base (6) and the circuit board arrangement (11), thus delimiting a receiving space (15);
- in each filter path (12₁, 12₂, ..., 12ₙ), at least one resonator inner conductor (13) is provided that is galvanically connected to the housing base (6) of the housing (5) and extends in the axial direction from the housing base (6) in the direction of the circuit board arrangement (11), and ends at a distance from the circuit board arrangement (11) and/or is galvanically separated from same;
- the individual filter paths (12₁, 12₂, ..., 12ₙ) in which at least one resonator inner conductor (13) is situated in each case are separated, at least partially, from one another by a wall (14) that is galvanically connected to the housing base (6) and extends in the direction of the circuit board arrangement (11);
and wherein the HF combiner arrangement (3) includes the following feature:
- the first and the second HF combiner (1; 1ₐ, 1_{b}) are placed one on top of the other, the circuit board arrangement (11) electrically and/or electromagnetically separating the receiving space (15) of the first HF combiner (1; 1ₐ) from the receiving space (15) of the second HF combiner (1; 1_{b}), and conversely.

15. A mobile radio site (4) having at least two HF combiners (1; 1ₐ, 1_{b}) according to any of claims 1 to 13 and/or at least one first HF combiner arrangement (3; 3ₐ) according to claim 14, comprises the following features:
- n base stations (50ₐ, 50_{b}, ..., 50ₙ), the n base stations (50ₐ, 50_{b}, ..., 50ₙ) being operable in different mobile radio bands;
- each of the n base stations (50ₐ, 50_{b}, ..., 50ₙ) has two signal terminals (50ₐ₁, 50ₐ₂, 50_{b1}, 50_{b2}, ..., 50ₙ₁, 50ₙ₂), the n base stations (50ₐ, 50_{b}, ..., 50ₙ) being designed for transmitting and/or receiving preferably a MAIN signal at a first signal terminal (50ₐ₁, 50_{b1}, ..., 50ₙ₁), and the n base stations (50ₐ, 50_{b}, ..., 50ₙ) being designed for transmitting and/or receiving preferably a DIV signal at a second signal terminal (50ₐ₂, 50_{b2}, ..., 50ₙ₂);
- the first signal terminals (50ₐ₁, 50_{b1}, ..., 50ₙ₁) of the n base stations (50ₐ, 50_{b}, ..., 50ₙ) are electrically connected to the n signal line terminals (9₁, 9₂, ..., 9ₙ) of the first HF combiner (1; 1ₐ) or of the first HF combiner (1; 1ₐ) of the first HF combiner arrangement (3; 3ₐ);
- the second signal terminals (50ₐ₂, 50_{b2}, ..., 50ₙ₂) of the n base stations (50ₐ, 50_{b}, ..., 50ₙ) are electrically connected to the n signal line terminals (9₁, 9₂, ..., 9ₙ) of the second HF combiner (1; 1_{b}) or of the second HF combiner (1; 1_{b}) of the first HF combiner arrangement (3; 3ₐ);
- a first and a second feeder cable (51ₐ, 51_{b});
- the first feeder cable (51ₐ) with its first end is electrically connected to the common terminal (8) of the first HF combiner (1; 1ₐ) or to the common terminal (8) of the first HF combiner (1; 1ₐ) of the first HF combiner arrangement (3; 3ₐ);
- the second feeder cable (51_{b}) with its first end is electrically connected to the common terminal (8) of the second HF combiner (1; 1_{b}) or to the common terminal (8) of the second HF combiner (1; 1_{b}) of the first HF combiner arrangement (3; 3ₐ).

## Revendications

1. Combineur HF (1) prévu pour l'emploi dans des sites radio mobiles (4), comprenant les particularités suivantes :
- au moins un boitier (5) avec une connexion commune (8) et n connexions de ligne de signal (9₁, 9₂, ..., 9ₙ), avec n ≥ 2, n ≥ 3 ou n ≥ 4, où la connexion commune (8) et les n connexions de ligne de signal (91, 92, ..., 9n) sont rapportées sur le boitier (5) ;
- les n connexions de ligne de signal (9₁, 9₂, ..., 9ₙ) sont reliées et/ou couplées à l'intérieur du boitier (5) avec la connexion commune (8) respectivement par le biais de n chemins de filtrage (12₁, 12₂, ..., 12ₙ) ;
- un ensemble de carte de circuit imprimé (11) ;
- l'ensemble de carte de circuit imprimé (11) présente un contact de connexion commun (18) qui est relié avec la connexion commune (8) de manière galvanique ;
- l'ensemble de carte de circuit imprimé (11) présente n contacts de connexion de ligne de signal (19₁, 19₂, ..., 19ₙ), où chacun des n contacts de connexion de ligne de contact (19₁, 19₂, ..., 19ₙ) est relié avec une des n connexions de ligne de signal (9₁, 9₂, ..., 9ₙ) de manière galvanique ;
- au moins un filtre passe-bas (17) est disposé entre la connexion commune (8) et le contact de connexion commune (18), et/ou respectivement au moins un filtre passe-bas (17) est disposé entre au moins une ou toutes les n connexions de ligne de signal (9₁, 9₂, ...,9ₙ) et le contact de connexion de ligne de signal (19₁, 19₂, ..., 19ₙ) correspondant ;
- l'ensemble de carte de circuit imprimé (11) comprend n lignes de dérivation (20₁, 20₂, ..., 20n) ;
- chacun des n contacts de connexion de ligne de signal (19₁, 19₂, ..., 19ₙ) est relié ou peut être relié électriquement avec le contact de connexion commune (18) par le biais respectivement d'une des n lignes de dérivation (20₁, 20₂, ..., 20ₙ) ;
- un dispositif électronique (2) qui présente un dispositif de commande (30), un dispositif détecteur (16) et au moins n dispositifs de commutation de ligne de signal (32₁, 32₂, ..., 32ₙ) ;
- les n dispositifs de commutation de ligne de signal (32₁, 32₂, ..., 32ₙ) comprennent respectivement au moins une première unité de commutation (32₁ₐ, 32₂ₐ, ..., 32ₙₐ), où l'au moins une première unité de commutation (32₁ₐ, 32₂ₐ, ..., 32ₙₐ) respective est disposée dans chacune des n lignes de dérivation (20₁, 20₂, ..., 20ₙ) ;
- le dispositif détecteur (16) est :
a) connecté ou couplé aux n contacts de connexion de ligne de signal (19₁, 19₂, ..., 19ₙ) ; ou
b) est connecté ou couplé entre les n connexions de ligne de signal (9₁, 9₂, ..., 9ₙ) et les n dispositifs de commutation de ligne de signal (32₁, 32₂, ..., 32ₙ) ;
- **caractérisé en ce que** le dispositif détecteur (16), dans un état de fonctionnement de station émettrice-réceptrice de base, BTS, est conçu pour détecter s'il y a un signal de groupe de normes d'interface d'antenne, AISG, au niveau d'un des n contacts de connexion de ligne de signal (19₁, 19₂, ..., 19ₙ) ;
- le dispositif de commande (30), ou le dispositif détecteur (16), lors de la détection d'un signal AISG au niveau d'un des n contacts de connexion de ligne de signal (19₁, 19₂, ..., 19n), est conçu pour démarrer la première unité de commutation (32₁ₐ, 32₂ₐ, ..., 32ₙₐ) dans les n lignes de dérivation (20₁, 20₂, ..., 20ₙ) respectives de telle manière que celle-ci relie électriquement celui parmi les n contacts de connexion de ligne de signal (19₁, 19₂, ..., 19ₙ), sur lequel le signal AISG a été détecté, avec le contact de connexion commune (18).

2. Combineur HF (1) selon la revendication 1, comprenant la particularité suivante :
- la liaison électrique, par le biais de laquelle le signal AISG est transmis du contact de connexion de ligne de signal (19₁, 19₂, ..., 19ₙ) correspondant au contact de connexion commune (18), est à faible résistance et/ou est exempte de convertisseurs de signal.

3. Combineur HF (1) selon la revendication 1 ou la revendication 2, comprenant les particularités suivantes :
- le dispositif électronique (2) présente un diviseur de signal commun (35) et n diviseurs de signal de connexion (36₁, 36₂, ..., 36ₙ) ;
- le diviseur de signal commun (35) et les n diviseurs de signal de connexion (18) comprennent respectivement une première, une deuxième et une troisième connexion, et sont conçus pour :
a) diviser un signal mélangé à base d'un signal CC et d'un signal AISG, lequel est sur la première connexion, et pour délivrer le signal CC à la deuxième connexion et le signal AISG à la troisième connexion ;
b) additionner un signal CC qui est à la deuxième connexion et un signal AISG qui est à la troisième connexion et le délivrer sous forme de signal mélangé à la première connexion ;
- le diviseur de signal commun (35) est relié électriquement avec sa première connexion avec le contact de connexion commune (18) ;
- chacun des n diviseurs de signal de connexion (36₁, 36₂, ..., 36ₙ) est relié électriquement avec sa première connexion avec un des n contacts de connexion de ligne de connexion (19₁, 19₂, ..., 19ₙ), ce par quoi chacune des n lignes de dérivation (20₁, 20₂, ..., 20ₙ) est divisée en un segment de ligne AISG (20₁ₐ, 20₂ₐ, ..., 20ₙₐ) et un segment de ligne CC (20_{1b}, 20_{2b}, ..., 20_{nb}), où le segment de ligne CC (20_{1b}, 20_{2b}, ..., 20_{nb}) commence à la deuxième connexion du diviseur de signal de connexion (36₁, 36₂, ..., 36ₙ) respectif et le segment de ligne AISG (20₁ₐ, 20₂ₐ, ..., 20ₙₐ) commence à la troisième connexion du diviseur de signal de connexion (36₁, 36₂, ..., 36ₙ) respectif ;
- les deuxièmes connexions des n diviseurs de signal de connexion (36₁, 36₂, ..., 36ₙ) sont reliées électriquement les unes aux autres et sont reliées électriquement avec la deuxième connexion du diviseur de signal commun (35) ;
- les troisièmes connexions des n diviseurs de signal de connexion (36₁, 36₂, ..., 36ₙ) sont reliées électriquement les unes aux autres et sont reliées électriquement avec la troisième connexion du diviseur de signal commun (35) ;
- une première unité de commutation (32₁ₐ, 32₂ₐ, ..., 32ₙₐ) d'un des n dispositifs de commutation de ligne de signal (32₁, 32₂, ..., 32ₙₐ) est respectivement disposée dans chaque segment de ligne AISG (20₁ₐ, 20₂ₐ, ..., 20ₙₐ).

4. Combineur HF (1) selon l'une des revendications précédentes, comprenant les particularités suivantes :
- la première unité de commutation (32₁ₐ, 32₂ₐ, ..., 32ₙₐ) des n dispositifs de commutation de ligne de signal (32₁, 32₂, ..., 32ₙ) est un relais ; et/ou
- les n dispositifs de commutation de ligne de signal (32₁, 32₂, ..., 32ₙ) comprennent respectivement au moins une deuxième unité de commutation (32_{1b}, 32_{2b}, ..., 32_{nb}), où
- une deuxième unité de commutation (32_{1b}, 32_{2b}, ..., 32_{nb}) d'un des n dispositifs de commutation de ligne de signal (32₁, 32₂, ..., 32ₙ) est disposée dans chaque segment de ligne CC (20_{1b}, 20_{2b}, ..., 20_{nb}),
où la deuxième unité de commutation (32_{1b}, 32_{2b}, .., 32_{nb}) des n dispositifs de commutation de ligne de signal (32₁, 32₂, ..., 32ₙ) est un relais.

5. Combineur HF (1) selon l'une des revendications précédentes, comprenant les particularités suivantes :
- le dispositif détecteur (16) est en outre :
a) raccordé ou couplé au contact de connexion commun (18) ; ou est
b) raccordé ou couplé entre la connexion commune (8) et les n dispositifs de commutation de ligne de signal (32₁, 32₂, ..., 32ₙ) ;
- le dispositif détecteur (16) est conçu pour détecter s'il y a un signal CC à l'un des n contacts de connexion de ligne de signal (19₁, 19₂, ..., 19ₙ) ;
- le dispositif détecteur (16) est conçu pour détecter s'il y a un signal CC sur le contact de connexion commune (18) ;
- le dispositif de commande (30) est conçu pour adopter un état de fonctionnement de démarrage lors du démarrage et à partir de celui-ci :
a) évoluer vers l'état de fonctionnement BTS lorsque le dispositif détecteur (16) détecte un signal CC à l'un des n contacts de connexion de ligne de signal (19₁, 19₂, ..., 19ₙ) ; ou
b) évoluer vers un état de fonctionnement de protocole ANT lorsque le dispositif détecteur (16) détecte un signal CC au contact du contact de connexion commun (18).

6. Combineur HF (1) selon la revendication 5, comprenant les particularités suivantes :
- le dispositif de commande (30) est conçu pour, dans l'état de fonctionnement BTS, relier électriquement les contacts en question des n contacts de connexion de ligne de signal (19₁, 19₂, ..., 19ₙ), sur lesquels un signal CC a été détecté en premier, avec le contact de connexion commune (18) par le démarrage du dispositif de commutation de ligne de signal (32₁, 32₂, ..., 32ₙ) correspondant, où le dispositif de commande (30), dans l'état de fonctionnement BTS, est en outre conçu pour séparer électriquement les autres contacts de connexion de ligne de signal (19₁, 19₂, ..., 19ₙ) en question, sur lesquels un signal CC a été détecté uniquement plus tard ou n'a pas été détecté du tout, du contact de connexion commune (18) par le démarrage des dispositifs de commutation de ligne de signal (32₁, 32₂, ..., 32ₙ) correspondants.

7. Combineur HF (1) selon la revendication 6, comprenant les particularités suivantes :
- le dispositif de commande (30) est conçu, dans l'état de fonctionnement BTS, pour, dans le cas où le dispositif détecteur (16) :
a) détecte un signal AISG à l'un des n contacts de connexion de ligne de signal (19₁, 19₂, ..., 19ₙ), démarrer le dispositif de commutation de ligne de signal (32₁, 32₂, ..., 32ₙ) correspondant de sorte que celui-ci relie électriquement le contact de connexion de ligne de signal (19₁, 19₂, .., 19ₙ) respectif avec le contact de connexion commune (18), de sorte que le signal AISG se produise sur le contact de connexion commune (18) ; ou
b) détecte un signal AISG et un signal CC à l'un des n contacts de connexion de ligne de signal (19₁, 19₂, ..., 19ₙ) de telle manière que celui-ci relie électriquement le contact de connexion de ligne de signal (19₁, 19₂, ..., 19ₙ) respectif avec le contact de connexion commune (18), de sorte que le signal AISG et le signal CC se produisent au contact de connexion commune (18), où le dispositif de commande (30) est en outre conçu pour démarrer les autres dispositifs de commutation de ligne de signal (32₁, 32₂, ..., 32ₙ) activés de telle manière que ceux-ci séparent une liaison électrique entre leurs contacts de connexion de ligne de signal (19₁, 19₂, ..., 19ₙ) respectifs et le contact de connexion commune (18).

8. Combineur HF (1) selon la revendication 7, comprenant la particularité suivante :
- le dispositif de commande (30) est conçu, dans l'état de fonctionnement BTS, pour, dans le cas où le dispositif détecteur (16) détecte un signal AISG et un signal CC à l'un des n contacts de connexion de ligne de signal (19₁, 19₂, ..., 19ₙ), où un autre contact de connexion de ligne de signal (19₁, 19₂, ..., 19ₙ) est déjà relié électriquement avec le contact de connexion commune (18) pour la transmission d'un signal CC, démarrer le dispositif de commutation de ligne de signal (32₁, 32₂, ..., 32ₙ) correspondant des contacts de connexion de ligne de signal (19₁, 19₂, ..., 19ₙ) en question sur lesquels le signal AISG et le signal CC ont été détectés, de telle manière que celui-ci relie électriquement le contact de connexion de ligne de signal (19₁, 19₂, ..., 19ₙ) respectif avec le contact de connexion commune (18), de sorte que le signal AISG et le signal CC s'y produisent, et séparent électriquement la liaison existante de l'autre contact de connexion de ligne de signal (19₁, 19₂, ..., 19ₙ) avec le contact de connexion commune (18), où ce changement se produit sans interruption de sorte que toujours un signal CC se produise sur le contact de connexion commune (18).

9. Combineur HF (1) selon l'une des revendications 6 à 8, comprenant la particularité suivante :
- le dispositif détecteur (16) est conçu pour détecter s'il y a un court-circuit sur le contact de connexion commune (18), où le dispositif de commande (30) est en outre conçu pour relier le contact de connexion de ligne de signal (19₁, 19₂, ..., 19ₙ) correspondant avec le contact de connexion commune (18) uniquement si aucun court-circuit n'a été détecté par le dispositif détecteur (16).

10. Combineur HF (1) selon l'une des revendications 5 à 9, comprenant la particularité suivante :
- le dispositif de commande (30) est conçu, dans l'état de fonctionnement de démarrage, pour démarrer les n dispositifs de commutation de ligne de signal (32₁, 32₂, ..., 32ₙ) de telle manière que ceux-ci interrompent les n lignes de dérivation (20₁, 20₂, ..., 20ₙ), ce par quoi les n contacts de connexion de ligne de signal (19₁, 19₂, ..., 19ₙ) sont séparés électriquement du contact de connexion commune (18).

11. Combineur HF (1) selon la revendication 5, comprenant la particularité suivante :
- le dispositif détecteur (16) est conçu pour détecter un court-circuit au niveau des n contacts de connexion de ligne de signal (19₁, 19₂, ..., 19ₙ), où le dispositif de commande (30) à l'état de fonctionnement ANT est conçu pour relier électriquement le contact de connexion commune (18) simplement avec les contacts en question des n contacts de connexion de ligne de signal (19₁, 19₂, ..., 19ₙ) par le démarrage des dispositifs de commutation de ligne de signal (32₁, 32₂, ..., 32ₙ) correspondants sur lesquels aucun court-circuit n'a été détecté.

12. Combineur HF (1) selon l'une des revendications 5 à 11, comprenant la particularité suivante :
- le dispositif de commande (30) est conçu pour, dans l'état de fonctionnement BTS ou dans l'état de fonctionnement ANT, démarrer les n dispositifs de commutation de ligne de signal (32₁, 32₂, ..., 32ₙ) de telles manière que ceux-ci séparent électriquement les n contacts de connexion de ligne de signal (19₁, 19₂, ..., 19ₙ) du contact de connexion commune (18) lorsqu'un niveau des signaux CC sur les n contacts de connexion de ligne de signal (19₁, 19₂, ..., 19ₙ) et le contact de connexion commune (18) diminue en-dessous d'une valeur de seuil réglable.

13. Combineur HF (1) selon l'une des revendications précédentes, comprenant la particularité suivante :
- le dispositif de commande (30), dans l'état de fonctionnement BTS, lors de la détection d'un signal AISG au niveau d'un des n contacts de connexion de ligne de signal (19₁, 19₂, ..., 19ₙ) par le dispositif détecteur (16), est conçu pour démarrer la première unité de commutation (32₁ₐ, 32₂ₐ, ..., 32ₙₐ) du dispositif de commutation de ligne de signal (32₁, 32₂, ..., 32ₙ) correspondant dans un intervalle de temps tel que la première impulsion de la touche Marche/Arrêt du signal AISG conçu sous forme de signal de touche Marche/Arrêt peut encore être transmise à plus de 70 %, 80 %, 90 % au contact de connexion commune (18).

14. Ensemble combineur HF (3) avec un premier et un second combineur HF (1 ; 1ₐ, 1_{b}) qui sont construits selon l'une des revendications précédentes, où le premier et le second combineur HF (1 ; 1ₐ, 1_{b}) comprennent en outre les particularités suivantes :
- le boitier (5) du premier et du second combineur HF (1 ; 1a, 1b) est construit sur le type de construction avec cavité et comprend un fond de boitier (6), l'ensemble de cartes de circuit imprimé (11) espacé par rapport au fond de boitier (6) et une paroi de boitier (7) périphérique entre le fond de boitier (6) et l'ensemble de cartes de circuit imprimé (11), ce par quoi un espace de réception (15) est délimité ;
- au moins un conducteur interne de résonateur (13) est disposé dans chaque chemin de filtrage (12₁, 12₂, ..., 12ₙ), qui est relié de manière galvanique avec le fond de boitier (6) du boitier (5) et s'étend dans la direction axiale à partir du fond de boitier (6) en direction de l'ensemble de cartes de circuit imprimé (11) et s'arrête à une distance par rapport à l'ensemble de cartes de circuit imprimé (11), et/ou est séparé de manière galvanique de celui-ci ;
- les chemins de filtrages (12₁, 12₂, ..., 12ₙ) individuels, dans lesquels au moins un conducteur interne de résonateur (13) est disposé, sont séparés les uns des autres au moins partiellement par une paroi (14) qui est reliée de manière galvanique avec le fond de boitier (6) et s'étend en direction de l'ensemble de cartes de circuit imprimé (11) ;
et où l'ensemble combineur HF (3) comprend la particularité suivante :
- le premier et le second combineur HF (1 ; 1a, 1b) sont empilés l'un sur l'autre, où l'ensemble de cartes de circuit imprimé (11) sépare électriquement et/ou électromagnétiquement l'espace de réception (15) du premier combineur HF (1 ; 1a) de l'espace de réception (15) du second combineur HF (1 ; 1_{b}) et inversement.

15. Site radio mobile (4) avec au moins deux combineurs HF (1 ; 1_{a,} 1_{b}) selon l'une des revendications 1 à 13 et/ou au moins un premier ensemble combineur HF (3 ; 3ₐ) selon la revendication 14, comprenant les particularités suivantes :
- n stations de base (50ₐ, 50_{b}, ..., 50ₙ), où les n stations de base (50ₐ, 50_{b}, ..., 50ₙ) peuvent fonctionner dans différentes bandes radio mobile ;
- chacune des n stations de base (50ₐ, 50_{b}, ..., 50ₙ) a deux connexions de signal (50ₐ₁, 50ₐ₂, 50_{b1}, 50_{b2}, ..., 50ₙ₁, 50ₙ₂), où les n stations de base (50ₐ, 50_{b}, ..., 50ₙ) sont conçues pour, au niveau d'une première connexion de signal (50ₐ₁, 50_{b1}, ..., 50ₙ₁), émettre et/ou recevoir de préférence un signal MAIN et les n stations de base (50ₐ, 50_{b}, ..., 50ₙ) sont conçues pour, au niveau d'une seconde connexion de signal (50ₐ₂, 50_{b2}, ..., 50ₙ₂), émettre et/ou recevoir de préférence un signal DIV ;
- les premières connexions de signal (50ₐ₁, 50_{b1}, ..., 50ₙ₁) des n stations de base (50ₐ, 50_{b}, ..., 50ₙ) sont reliées électriquement avec les n connexions de ligne de signal (9₁, 9₂, ..., 9ₙ) du premier combineur HF (1 ; 1ₐ) ou du premier combineur HF (1 ; 1ₐ) du premier ensemble combineur HF (3 ; 3ₐ) ;
- les secondes connexions de signal (50ₐ₂, 50_{b2}, ..., 50ₙ₂) des n stations de base (50ₐ, 50_{b}, ..., 50ₙ) sont reliées électriquement avec les n connexions de ligne de signal (9₁, 9₂, ..., 9ₙ) du second combineur HF (1 ; 1_{b}) ou du second combineur HF (1 ; 1_{b}) du premier ensemble combineur HF (3 ; 3ₐ) ;
- un premier et un second câble d'alimentation (51ₐ ; 51_{b}) ;
- le premier câble d'alimentation (51ₐ) est relié électriquement avec sa première extrémité avec la connexion commune (8) du premier combineur HF (1 ; 1ₐ) ou avec la connexion commune (8) du premier combineur HF (1 ; 1ₐ) du premier ensemble combineur HF (3 ; 3ₐ);
- le second câble d'alimentation (51_{b}) est relié électriquement avec sa première extrémité avec la connexion commune (8) du second combineur HF (1 ; 1_{b}) ou avec la connexion commune (8) du second combineur HF (1 ; 1_{b}) du premier ensemble combineur HF (3 ; 3ₐ).
